Europäisches Patentamt

European Patent Office

Office européen des brevets

(11) Publication number: **0 566 739 A1**

## EUROPEAN PATENT APPLICATION
### published in accordance with Art. 158(3) EPC

(21) Application number: **92902751.4**

(22) Date of filing: **10.01.92**

(86) International application number:
**PCT/JP92/00014**

(87) International publication number:
**WO 92/12498 (23.07.92 92/19)**

(51) Int. Cl.5: **G06G 7/60**

(30) Priority: **12.01.91 JP 13780/91**

(43) Date of publication of application:
**27.10.93 Bulletin 93/43**

(84) Designated Contracting States:
**BE DE FR GB IT NL**

(71) Applicant: **SHIBATA, Tadashi**
**5-2, Nihondairai,**
**Taihaku-ku**
**Sendai-shi, Miyagi-ken 980(JP)**

(72) Inventor: **SHIBATA, Tadashi 5-2, Nihondaira**
**Taihaku-ku**
**Sendai-shi Miyagi-ken 980(JP)**
Inventor: **OHMI, Tadahiro 1-17-301,**
**Komegabukuro 2-chome**
**Aoba-ku**
**Sendai-shi Miyagi-ken 980(JP)**

(74) Representative: **Weitzel, Wolfgang, Dr.-Ing.**
**Friedenstrasse 10**
**D-89522 Heidenheim (DE)**

(54) SEMICONDUCTOR DEVICE.

(57) A semiconductor device capable of realizing a neuro-computer chip of high integration degree and low power consumption. The device consumes a very small amount of electric power and the combinations of synapes can be realized, using a small number of elements. A first MOS type transistor includes a first gate electrode floating in potential and provided in a region isolating a source region from a drain region via a first insulation film, and plural second gate electrodes capacitively coupled to the first gate electrode via a second insulation film, one of which is in connection with a source electrode. The gate or drain electrode of the MOS type transistor is in connection with a first wiring for transferring signals of high or low level in potential.

Fig. 1

## Technical Field

The present invention relates to a semiconductor device, and more particularly a highly functional semiconductor integrated circuit to realize a neural network computer or a neuron computer.

## Background Art

A semiconductor integrated circuit technology has rapidly progressed. For example, in the case of dynamic memory, memory chips with a capacity of 4 though 16 Mbit have been already put into mass production and ultra high integration memory chips with 64 Mbit are now being developed, in which about 120 million MOS transistors are integrated on a silicon chip with an area of 1 $cm^2$. Such an ultra high integration technology is applied to a logic circuit as well as a memory circuit, and a variety of functional logic circuits represented by 32 bit CPU or 64 bit CPU are also under development

In these logic circuits, arithmetic operation is carried out by using digital signals, i.e., binary signals composed of 1 and 0. For example, a Neumann method is adopted for a computer, where commands are executed one by one according to a program. Simple numerical calculations can be done at very high speed by this method; however, it takes enormous long time to implement the pattern recognition or image processing. Furthermore, this method is not suitable for information processing such as association of ideas and learning. In spite of a lot of research and development activities to deal with these information processing using software technology, remarkable results have not been produced yet.

There has been another stream of research to get rid of these difficulties at once and then to construct a computer which imitates the arithmetic operations of the brain, i.e., neuron computer by studying the function of brain. This kind of research began in 1940s and becomes very active in last several years since the progress in LSI technology may has suggested the possibility to realize the hardware of a neuron computer.

However, the present semiconductor LSI technology still has so many problems that the prospect for practical application is still far from certain.

Technical problems in fabricating an LSI chip of neuron computer with the current LSI technology are described in the following.

In spite of complicated structure and high function, the brain is made of very simple basic unit, which consists of a nerve cell called neuron performing arithmetic operation and a nerve fiber acting as an interconnect to transmit the result of arithmetic operation to other neurons.

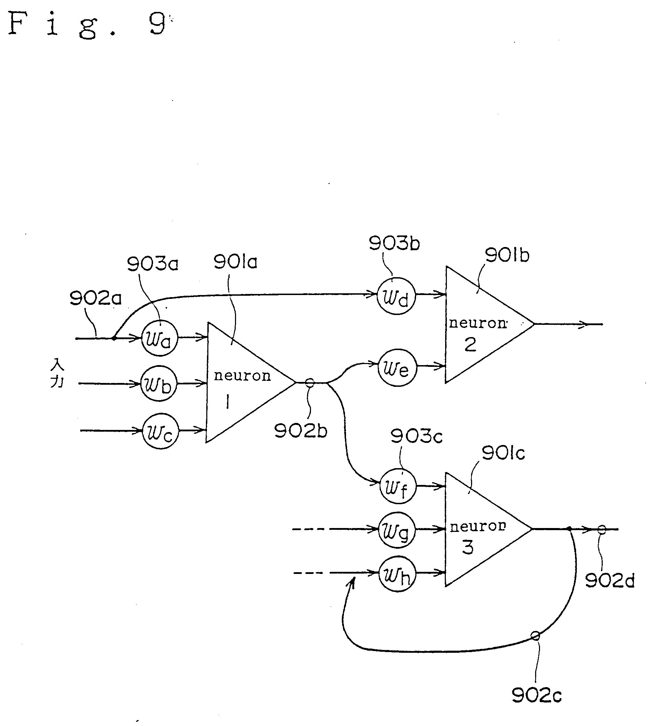

The unit of brain is simplified and then described in Fig. 9. In the figure, 901a, 901b and 901c are neurons. 902a, 902b and 902c are nerve fibers. 903a, 903b and 903c are called as synapse couplings. For example, a signal transmitted thorough nerve fiber 902a is multiplied by weight $W_a$ at synapse coupling 903a and the weighted signal is inputted to neuron 901a. Neuron 901 sums up inputted signals and is activated to output signal (namely, the neuron gets fired) when the sum is larger than a threshold value. On the other hand, the neuron outputs no signal when the sum is less than the threshold value.

Such phenomena as arithmetic operation, transmission of signal, and weight multiplication are carried out electrochemically in a real brain, and signals are transferred and processed as electric signal. The learning process of human is correlated to the change in weights of synapse couplings. The weight is gradually modified to the optimum value to have correct output for various combinations of inputted signals. In other words, the knowledge is stored in the brain as weights of synapse couplings.

A number of neurons are mutually connected, forming a layer and it is known that six layers are stacked in the human brain. In realizing a neuron computer, it is the most important matter to construct LSI system with above-mentioned structure and function.

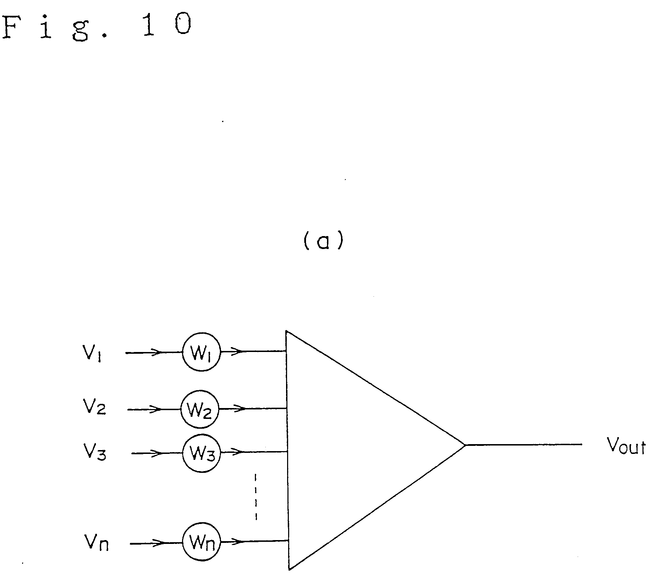

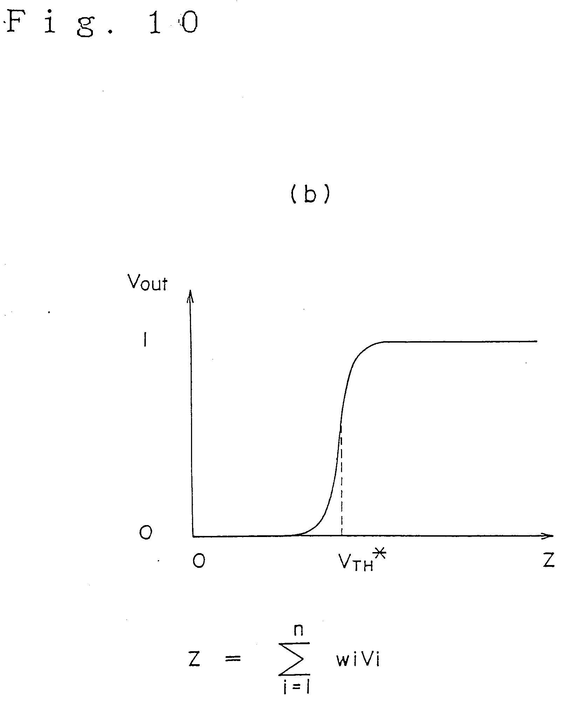

Fig. 10 is a schematic representation illustrating the function of a nerve cell, i.e., neuron, which was proposed by McCumllock and Pitts as a mathematical model of neuron ( Bull. Math. Biophys., Vol.5, p.115 (1943)). At present, the studies are being carried out actively to construct a neuron computer by realizing this model with semiconductor circuits. $V_1$, $V_2$, $V_3$,···, $V_n$ are n input signals defined as, for example, magnitudes of voltages, and correspond to signals transferred from another neurons. $W_1$, $W_2$, $W_3$, ···, $W_n$ are coefficients representing the coupling strength between neurons, and are biologically called synapse coupling. The function of this neuron is that when the value Z, the linear sum of products of input $V_i$ and respective weight $W_i$ ( i = 1 - n ), becomes larger than a predetermined threshold value $V_{TH}^*$, the neuron outputs 1; on the other hand, 0 when Z is less than $V_{TH}^*$. The numerical expression is given as follows:

$$Z \equiv \sum_{i=1}^{n} W_i V_i \qquad (1)$$

$$V_{out} = \begin{cases} 1 & (Z > V_{TH}^{*}) \qquad (2) \\ \\ 0 & (Z < V_{TH}^{*}) \qquad (3) \end{cases}$$

Fig. 10(b) shows the relationship Between Z and $V_{out}$. The output is 1 when Z is large enough as compared with $V_{TH}^{*}$, and 0 when Z is large enough

In order to construct the neuron using conventional transistors, a large number of transistors are required. Furthermore, since the sum operation is carried out after signals are converted to electric current, a large amount of current flows, resulting in large power dissipation. This means the integration of neurons is substantially impossible.

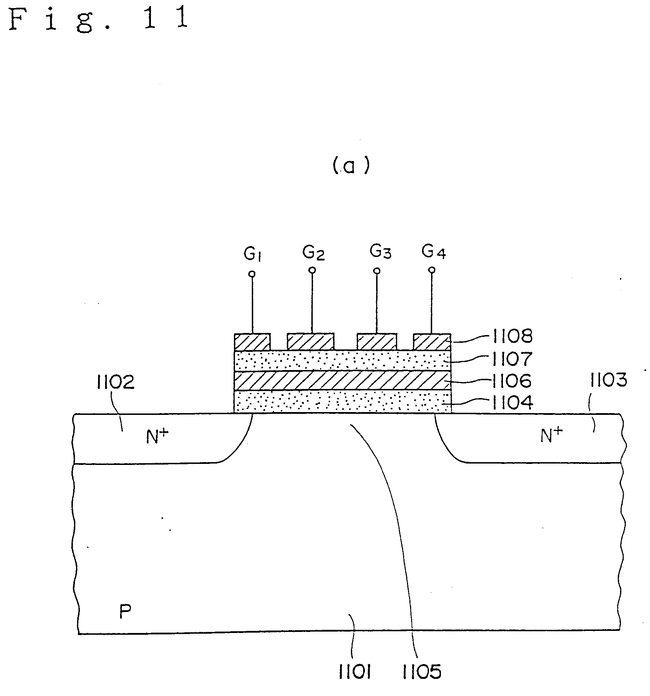

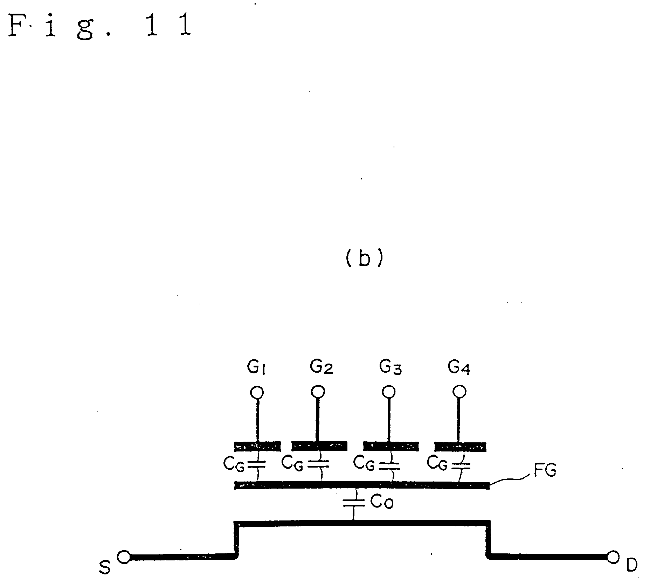

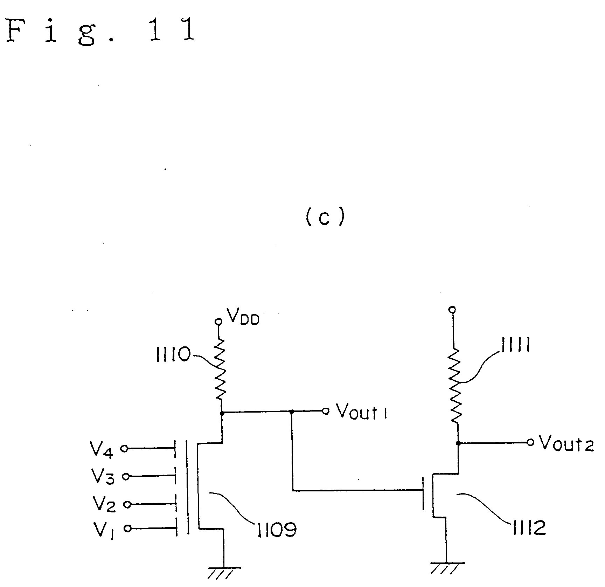

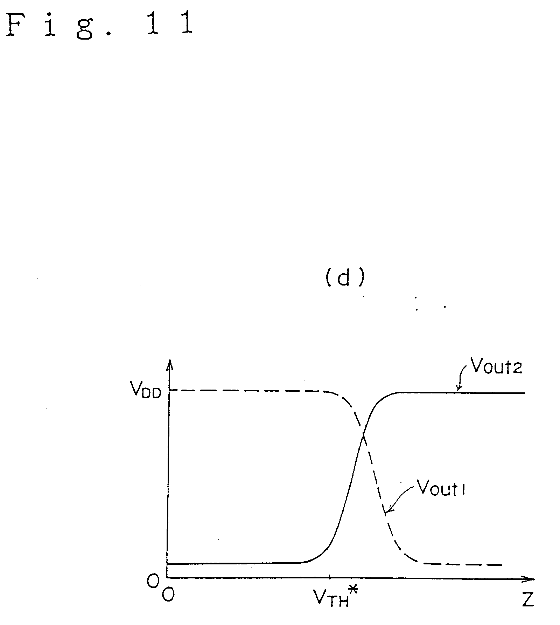

However, this problem has been overcome by the invention of Neuron MOSFET ( $\nu$MOS ) made by the present inventors ( Japanese Patent Application Heil-141463). This invention is epoch-making such that the principal function of a neuron is attained using single transistor and that little power is dissipated because the sum operation is carried out on the basis of voltage mode. Fig. 11(a) shows a cross-sectional diagram of $\nu$MOS, where 1101 is, e.g., a P-type silicon substrate, 1102 and 1103 are source and drain formed with $N^+$ diffusion layer, 1104 is a gate insulating film such as $SiO_2$ film formed on a channel region, 1106 is a floating gate electrically isolated, 1107 is, e.g., an insulating film such as $SiO_2$ and 1108 ($G_1$, $G_2$, $G_3$, $G_4$) are input gates which correspond to the input part of neuron.

Fig. 11(b) is a simplified diagram to explain the performance of neuron. Let capacitive coupling coefficient between each input gate and the floating gate be $C_G$ and that between the floating gate and the silicon substrate be $C_O$, leading to floating gate potential Z as:

$$Z = -W ( V_1 + V_2 + V_3 + V_4 ) \qquad (4)$$

$$W = C_G / ( C_O + 4 C_G ) \qquad (5)$$

Here, $V_1$, $V_2$, $V_3$ and $V_4$ are voltages inputted to input gates $G_1$, $G_2$, $C_3$ and $G_4$, respectively and the potential of silicon substrate is 0 V; that is, the substrate is grounded.

The $\nu$MOS is regarded as an ordinary N-channel MOS transistor with the floating gate acting as a gate electrode. A threshold voltage seen from the floating gate ( at which an inversion layer is formed on the substrate surface ) is expressed by $V_{TH}^{*}$. Accordingly, $\nu$MOS turns on When $Z > V_{TH}^{*}$ and turns off when $Z < V_{TH}^{*}$. Therefore, the combination of $\nu$MOS 1109 and single inverter as shown in Fig. 11(c) makes it possible to attain the function of a neuron. 1110 and 1111 denote resistors to construct an inverter. 1112 denotes an NMOS transistor. Fig. 11(d) represents $V_{OUT1}$ and $V_{OUT2}$ as a function of Z. $V_{OUT2}$ becomes the high voltage level of $V_{DD}$ for $Z > V_{TH}^{*}$; the state where the neuron gets fired is realized.

As is shown in Eq. 4, the basic performance of a neuron is that the sum of input signals to a neuron is calculated in the voltage mode, and the neuron gets fired when the sum exceeds $V_{TH}^{*}$ is realized by single $\nu$MOS. Because of the sum calculation in the voltage mode, the current at input stage flows only to charge or discharge the capacitances and therefore the amount of current is very little. On the other hand, direct current flows through the inverter when the neuron gets fired since resistor 1110 is used as a load. By using a $\nu$MOS gate of CMOS configuration shown in the previous invention ( Japanese Patent Application Heil-141463), the direct current can be prevented.

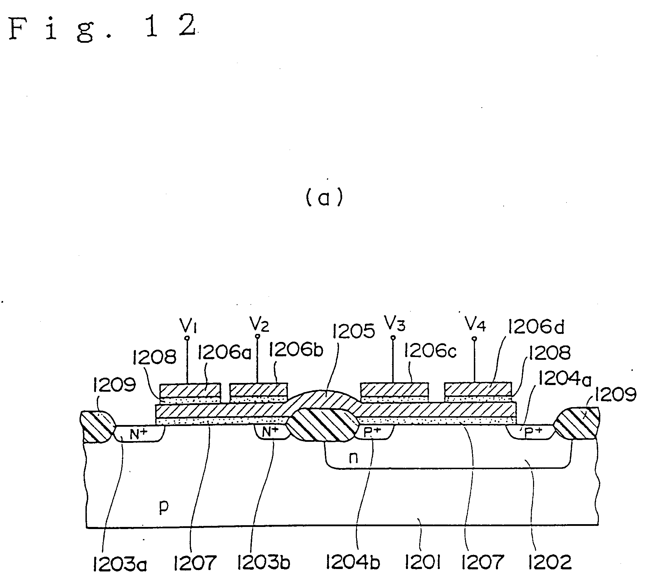

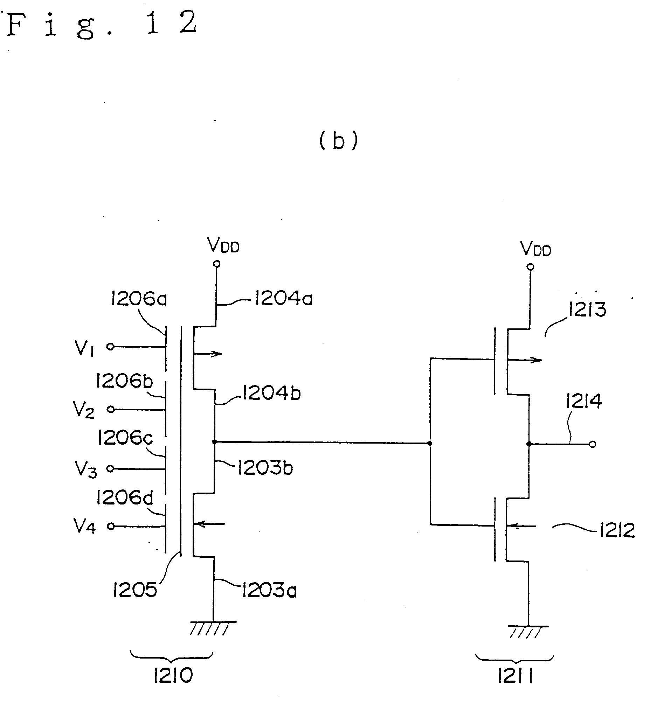

Fig.12 is an example of CMOS configuration. Fig. 12(a) represents a cross-sectional diagram of the CMOS neuron gate, where 1210 denotes a P-type silicon substrate, 1202, N-type well, 1203a and 1203b, $N^+$-type source and drain, respectively, 1204a and 1204b, $N^+$-type source and drain, respectively, 1205, a floating gate, 1206a - 1206d, insulating films such as $SiO_2$, and 1209, a field oxide film.

Fig. 12(b) represents an example of single neuron circuit configuration, where 1210 is the symbol of the CMOS gate which is shown in Fig. 12(a). The same numerals as in Fig. 12(a) are used for the corresponding parts. 1211 denotes a CMOS inverter, 1212 and 1213, NMOS and PMOS, respectively, and 1214, the output of the neuron. As mentioned, a neuron can be constructed with a small number of

EP 0 566 739 A1

elements and power dissipation is very little, indicating that $\nu$MOS is inevitable in realizing a neuron computer.

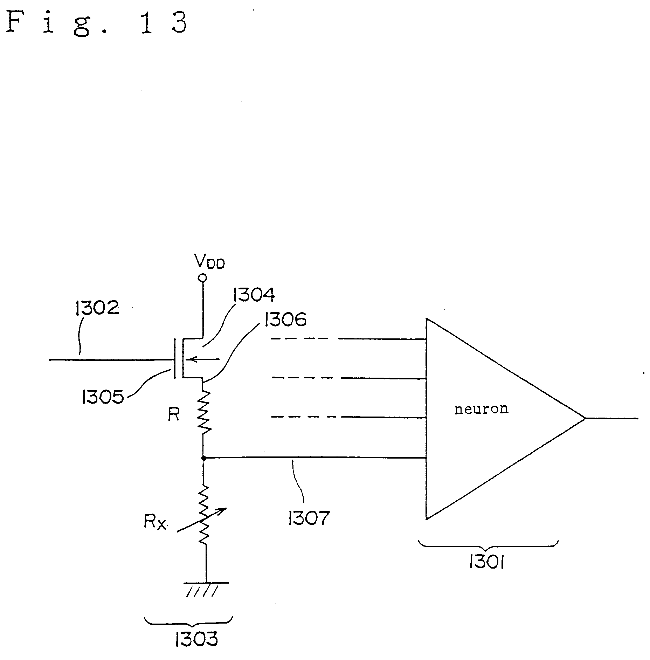

In addition to a neuron, another important element, a synapse, is required to realize a neuron computer. Fig. 13 represents a basic configuration of a conventional neuron circuit which contains synapse couplings together with a $\nu$MOS transistor. 1301 is, a neuron circuit as shown in e.g. Fig. 11(c). 1302 is an interconnect through which the output of another neuron is transferred. 1303 is a synapse circuit to put weight on signal, consisting of a source follower circuit where source 1306 of NMOS transistor 1304 is connected to resistors ( R + $R_X$). Therefore, when the output voltage $V_s$ of fired neuron is applied to the gate electrode 1305 of NMOS transistor 1304, the potential of source 1306 becomes $V_s$ - $V_{TH}$ where $V_{TH}$ is a threshold voltage of NMOS transistor 1304.

For the case of $V_{TH}$ = 0, the potential of source 1306 is $V_s$. The voltage is divided by two resistors R and $R_X$ to be the output of the synapse circuit which is transferred to neuron 1301 through interconnect 1307. The output voltage is expressed by $V_s R_X/( R + R_X)$, showing that the signal voltage $V_s$ is multiplied by weight $R_X/( R + R_X)$ and that the weight can be changed by $R_X$.

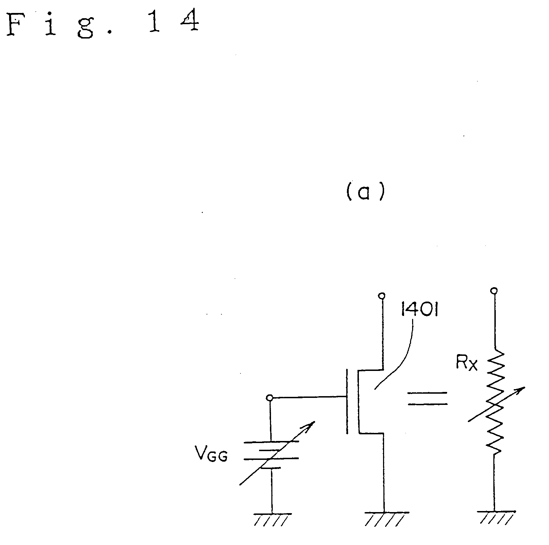

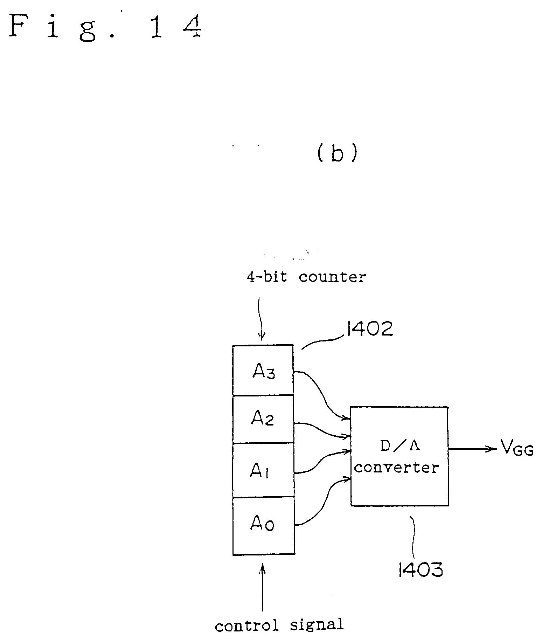

Fig. 14(a) represents a method to obtain a variable resistor. For example, with the application of constant voltage $V_{GG}$ to the gate of MOS transistor 1401, the transistor act as a resistor. Therefore, the resistance can varies with the value of $V_{GG}$.

Fig. 14(b) represents an example of circuits to control the value of $V_{GG}$ which consists of a binary counter 1402 and a D/A converter 1403. The coupling strength of synapse is expressed by 4-bit binary number which is to be converted to analogue voltage by D/A converter 1403 and outputted as $V_{GG}$. In order to strengthen the synapse coupling, the value of $V_{GG}$ is increased by ascending the value of the counter and the value is decreased by descending the value of the counter.

Next, the problems of the synapse circuit shown in Figs. 13 and 14 are extracted.

The first problem is that the generation of weight is made by using voltage division in Fig. 13. Since the current always flows through the resistors in this method to hold the weighted output voltage, the power of $(R + R_X) \cdot V_s^2/2$ is always dissipated. Even if the power dissipation at neuron 1302 is reduced by the use of $\nu$MOS, the whole power dissipation of the circuit will not be reduced enough. For the case of two-layer neural network, each of which has n neurons, the number of synapse couplings is $n^2$; the number of synapse couplings is much larger than that of neurons. Therefore, it is impossible because of too much power dissipation to design a neural network for practical use with the synapse coupling circuits which require stationary flow of current.

The second problem is that high integration of the circuit which determines the weight of the coupling is impossible to be realized because the circuit shown in Fig. 14(b) requires a large number of elements. For the neural network having the learning function, the strength of each synapse coupling is required to be suitably changed and memorized. A 4-bit binary counter in Fig. 14(b) is used for this purpose, but at least 30 transistors are necessary for the counter. A large number of elements are also necessary for constructing a D/A converter. Furthermore, these circuits dissipate more power per synapse coupling and thus are disadvantageous in terms of power dissipation.

In short, conventional technology cannot actually provide a neural network of low power dissipation and high integration. It is impossible to realize a neuron computer using prior art technology.

The present invention is made to overcome these problems. The aim of the invention is to provide a semiconductor device which can construct synapse coupling dissipating very little power using a small number of elements and to realize a low power dissipation, highly integrated neuron computer chip.

**Disclosure of the Invention**

A semiconductor device of the present invention comprises a first semiconductor region on a substrate, first source and first drain regions of opposite conductivity type to that of said first semiconductor region formed in the said first semiconductor region, a first gate electrode floating in potential formed over the region separating said first source and first drain regions through a first insulating film, a plurality of second gate electrodes capacitively coupled with said first electrode through a second insulating film, and a first MOS type transistor, wherein the source electrode of said first MOS type transistor is connected to one of said second gate electrodes and at least the gate or the drain electrode is connected to a first interconnect which transfers two-level voltage signal of high or low level.

4

(Operation)

By the semiconductor device of the present invention, which dissipates very little power and makes it possible to construct a synapse coupling with a small number of elements, the high integration and low power dissipation of neural network system becomes possible. As a result, a neuron computer chip is realized for the first time at practical use level.

**Brief Description of the Drawings**

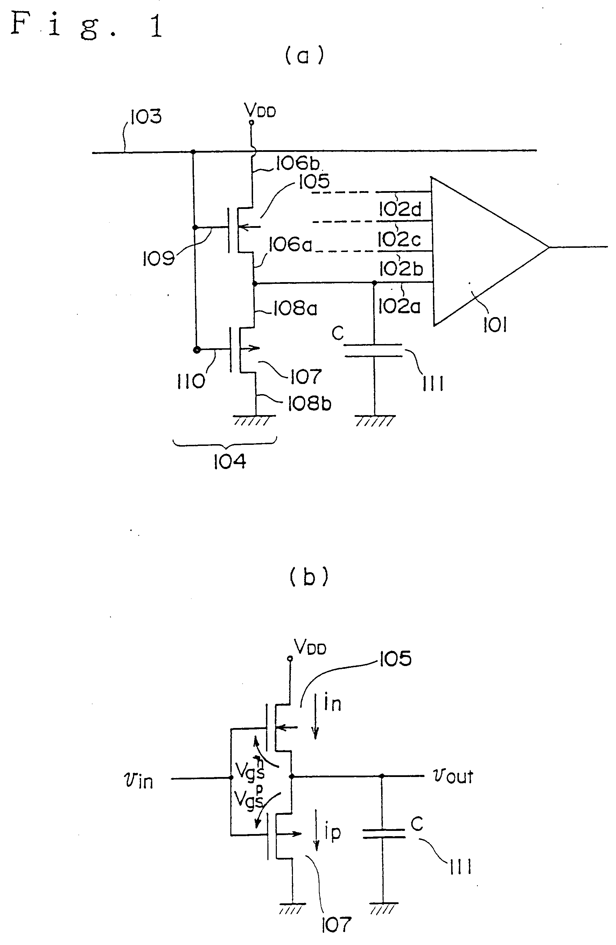

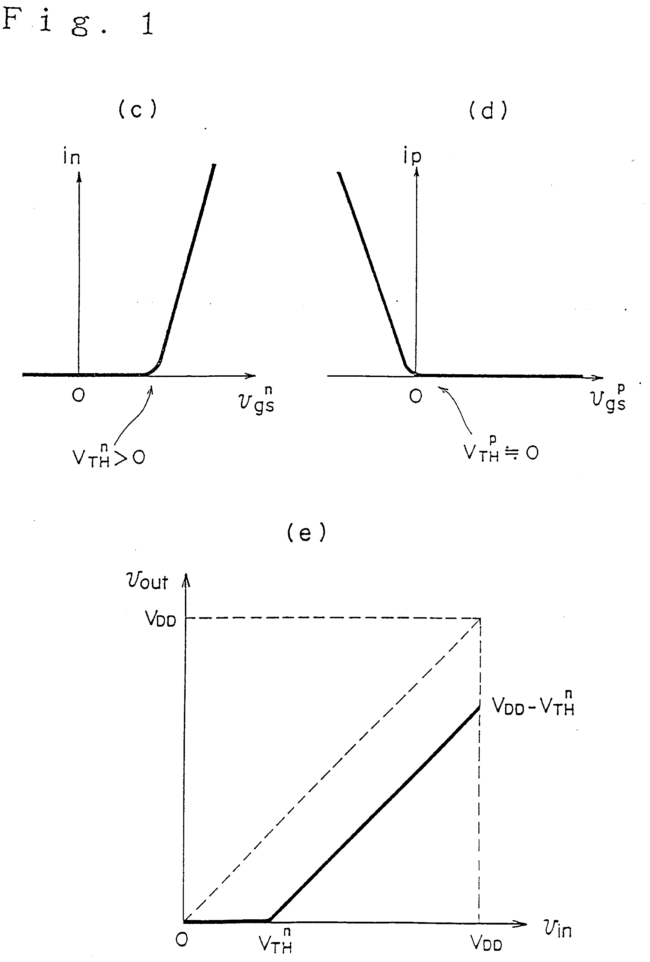

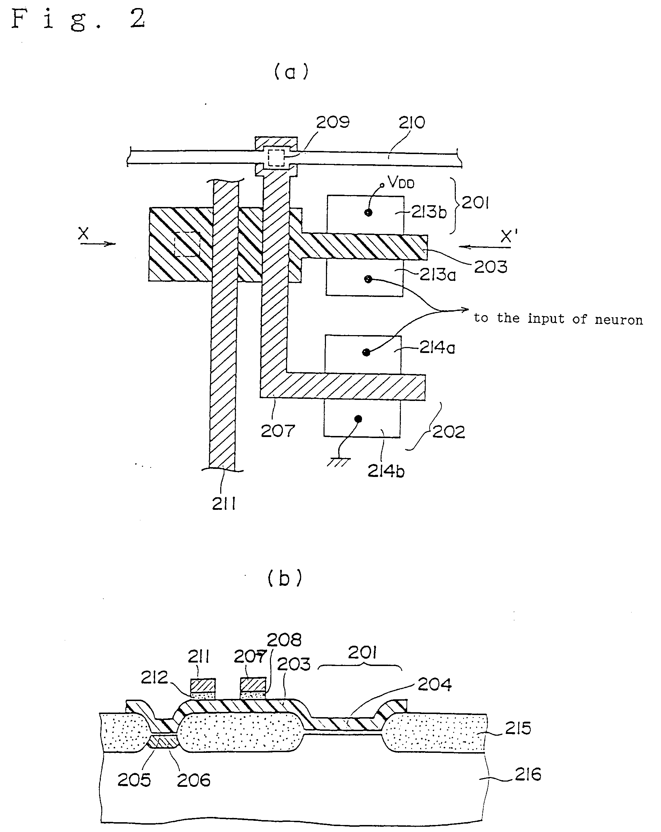

Fig. 1(a) is a circuit diagram representing embodiment 1. Fig. 1(b) is a circuit diagram of a synapse coupling circuit 104 shown in Fig. 1(a). Figs. 1(c) and 1(d) are graphs showing the relationships between $i_n$ and $V_{gs}^n$, and between $i_p$ and $V_{gs}^p$, respectively. Fig. 1(e) a graph showing $V_{out}$ as a function of $V_{in}$ from 0 V to $V_{DD}$.

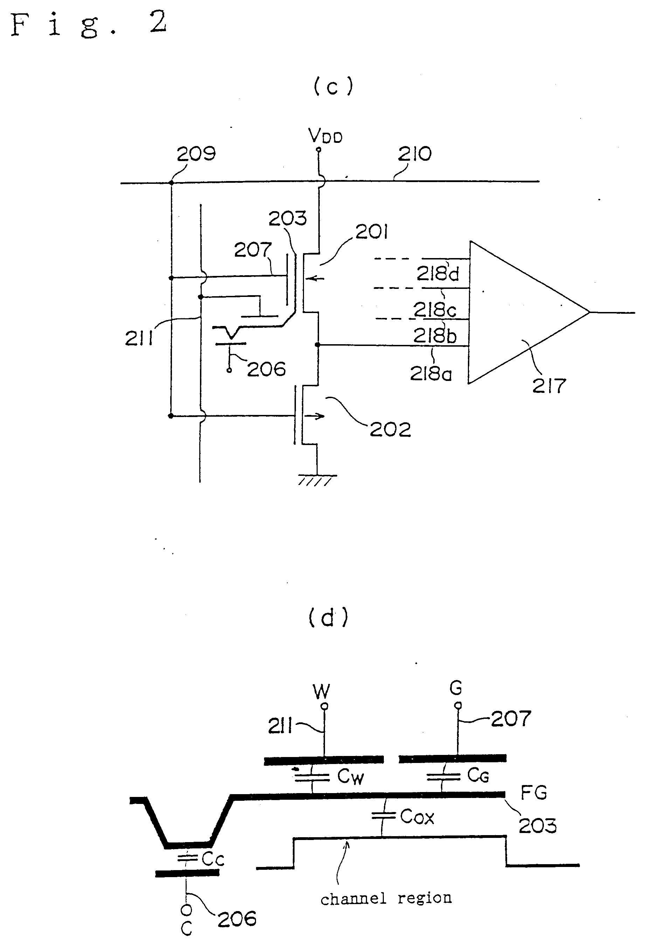

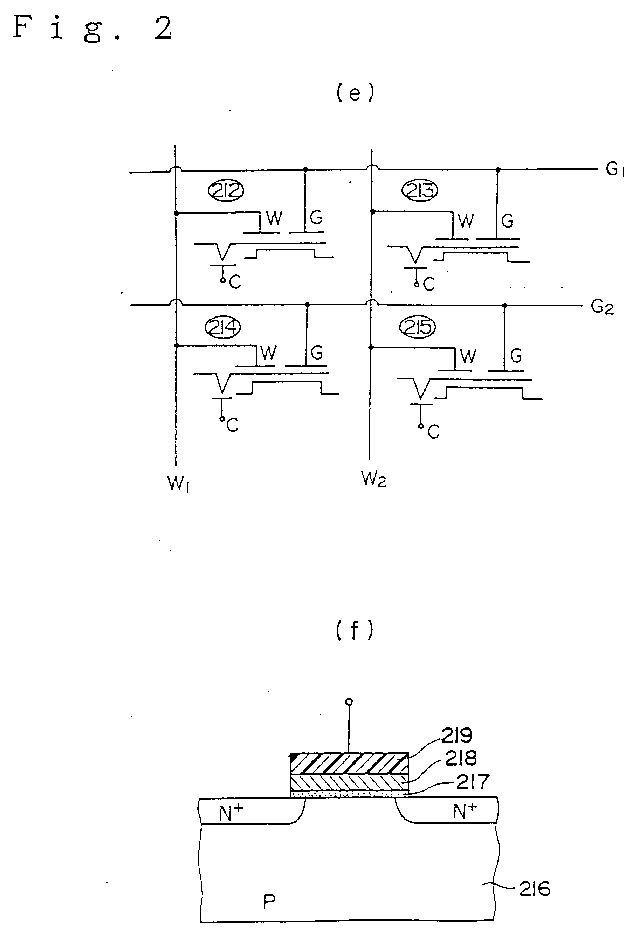

Fig, 2(a) shows a schematic diagram of embodiment 2. Fig. 2(b) is a cross-sectional view along X-X' line of Flg. 2(a). Fig. 2(c) is a schematic diagram of the semiconductor device having synapses and a neuron where the neuron is expressed by the symbol. Fig. 2(d) is a circuit diagram showing principal part of the synapse; i.e. NMOS having a floating gate. Fig. 2(e) is a circuit diagram where the synapse couplings shown in Fig. 2(d) are arranged in matrix configuration. Fig. 2(f) shows a cross-sectional view of a non-volatile memory element with ferroelectric film.

Fig. 3(a) is a graph showing the characteristic of depletion type PMOSFET. Figs. 3(b) and 3(c) are graphs showing the time-response characteristics of the circuit shown in Fig. 1(b). Fig. 3(d) shows another example of this invention. Figs. 3(e) - 3(g) show other examples of circuits.

Fig. 4(a) is a circuit diagram explaining embodiment 3. Fig. 4(b) is a schematic diagram of the synapse coupling shown in Fig. 4(a).

Fig. 5(a) shows an example of layout of neural network which consists of single synapse coupling and single neuron 502. Fig. 5(b) explains materials used in Fig. 5(a).

Figs. 5(c) and 5(d) are cross-sectional views along X-X' and Y-Y' lines of Fig. 5(a), respectively.

Fig. 6(a) is a circuit diagram of embodiment 5. Fig. 6(b) is a simplified diagram of Fig. 6(a).

Fig. 7(a) is a diagram of 4-layer neural network represented by using the notations of Fig. 6(b), which explains embodiment 6. Fig. 7(b) shows I(n) part of Fig. 7(a).

Fig. 8(a) is a circuit diagram explaining embodiment 7. Fig. 8(b) is a graph showing the relationship between $V_{in}$ and $V_{out}$ in Fig. 8(a).

Fig. 9 is a schematic diagram explaining the fundamental unit structure of a cerebral nerve cell.

Fig. 10(a) is a schematic diagram explaining the function of single neuron. Fig. 10(b) is a graph showing the relationship between Z and $V_{out}$.

Fig. 11(a) is a cross-sectional view of $\nu$MOS. Fig. 11(b) is a schematic diagram explaining the operation of $\nu$MOS in Fig. 11(a). Fig. 11(c) is a circuit diagram of inverter using $\nu$MOS shown in Fig. 11(a). Fig. 11(d) is a graph showing $V_{OUT1}$ and $V_{OUT2}$ in Fig. 11(c) as a function of Z.

Fig. 12(a) is a cross-sectional diagram of CMOS neuron gate. Fig. 12(b) is a diagram showing single neuron circuit.

Fig. 13 is a circuit diagram showing the fundamental unit structure of a prior art neuron circuit having synapse couplings constructed using an MOS transistor.

Fig. 14(a) is a circuit diagram explaining a prior art method for realizing a variable resistor. Fig. 14(b) is a diagram of a circuit controlling $V_{GG}$ of Fig. 14 (a).

**Best mode for carrying out the Invention**

(Embodiment 1)

The first embodiment is explained by referring to Fig. 1. Fig. 1(a) is a circuit diagram of embodiment 1, where 101 denotes a neuron circuit as shown in e.g. Fig. 11 or 12. In terms of less power dissipation, the circuit of Fig. 12 is preferable. 102a - 102d denote input terminals of the neuron circuit, corresponding to e.g. 1206a - 1206d of the circuit of Fig. 12. 103 denotes an interconnect which transfers the output signal of a neuron and hold the potential of $V_{DD}$ or 0V depending on whether the neuron is fired or not. 104 is a circuit which act as a synapse, connecting the output 103 of the neuron and the input 102a of neuron 101. 105 denotes an NMOS transistor. 106a and 106b are source and drain of the NMOS transistor, respectively. 107, 108a and 108b denotes a PMOS transistor, its source and drain, respectively. The source electrode 106a, 108a of NMOS and PMOS are connected to one 112a of input terminals of the neuron. The drains 106b, 118b of NMOS and PMOS are respectively connected to $V_{DD}$ and the ground. The gate electrodes 109, 110 of NMOS and PMOS are connected to interconnect 103. A capacitor C 111 is not an element that is installed, but a capacitance accompanying input terminal 102, such as incidental capacitance.

In order to explain the operation of this circuit, only synapse circuit 104 is shown in Fig. 1(b). The voltages between the gate and source $V_{gs}^n$, $V_{gs}^p$ of and currents $i_n$, $i_p$ flowingthrough NMOS and PMOS are defined as shown in Fig. 1(b), leading to the relationships $i_n$ - $V_{gs}^n$ and $I_p$ - $V_{gs}^p$ shown in Figs. 1(c) and 1(d), respectively. NMOS is an enhancement type ($V_{TH}^n > 0$), and the threshold $V_{TH}^p$ of PMOS is set at nearly 0 V.

When $V_{in}$ in the circuit of Fig. 1(b) is changed from 0 V to $V_{DD}$, $V_{out}$ varies as shown in Fig. 1(e). In the case of $V_{in}$ = 0 V and $V_{out}$ > 0, $V_{gs}^p$ < 0. Then, PMOS transistor 107 is on and the capacitor C continues to discharge till $V_{out}$ = 0. In this case, NMOS transistor 105 is off since $V_{gs}^n$ = 0.

When $V_{in}$ is gradually increased and $V_{in}$ > $V_{TH}^n$, NMOS transistor turns on and current $i_n$ flows, which charges up the capacitor C and increases $V_{out}$. $V_{out}$ is given by:

$$V_{out} = V_{in} - V_{TH}^n \qquad (6)$$

In this case, transistor 107 is off and no current flows ($i_p$ = 0) since the positive bias of $V_{gs}^p$ = $V_{TH}^n$ is always applied to the gate of PMOS. Namely, the level of $V_{out}$ can be maintained without any direct current in this synapse circuit. When the neuron at the previous stage is not fired ($V_{in}$ = 0), the voltage of 0 V ($V_{out}$ = 0 V) is inputted to the neuron 101 at the next stage. When the preceding neuron is fired, the voltage determined by Eq. (6) is inputted to the following neuron.

For $V_{in}$ = $V_{DD}$, Eq. (6) is revised as:

$$V_{out} = V_{DD}( 1 - V_{TH}^n/V_{DD})$$

and the weight used at the synapse is given by;

$$W = ( 1 - V_{TH}^n/V_{DD} ) \qquad (7)$$

Namely, the weight W can be determined by the threshold $V_{TH}^n$ of NMOS transistor 105.

Thus, by setting each threshold value of NMOS at appropriate value, a neural network with fixed values of synapse couplings is realized. In order that each NMOS transistor has a different threshold value, the amount of impurity such as B, P or As ion implanted into the channel part should be individually controlled for each NMOS transistor during manufacturing process; for example, the prescribed amount of ion is bombarded on the channel with the aid of the focused ion beam technology (FIB). The neural network thus obtained has no learning function, but can deal with specific problems such as a circulating salesman problem at very high speed.

The neural network of this embodiment has such remarkable feature that only charging and discharging currents flow in the synapse couplings and therefore the power dissipation can be almost disregarded as compared with a prior art synapse coupling of resistance division type (Fig. 13). This network is also characterized by that the synapse is suitable for high integration because of being constructed with only two transistors and small occupied area on the chip.

In the prior art circuit (Fig. 13), the potential of interconnect 103 is changed from 0 V to $V_{DD}$ and the capacitor C is charged up through NMOS transistor 1304 and resistor R. On the other hand, the charge up of the capacitor is made through only the NMOS transistor 105 in this embodiment, indicating that the operation speed can be increased as a result of decrease in effective resistance.

The drain 106b of NMOS transistor 105 which is connected to $V_{DD}$ in Fig. 1(a) can be connected to the signal line 103 as well. In this case, the output of a neuron circuit at the previous stage should have large capacity to supply current, since the signal line 113 is also required to supply current to charge up the capacitor C. That is, no power supply line to supply $V_{DD}$ to each synapse is necessary, which results in the decrease of the number of interconnects.

(Embodiment 2)

The second embodiment of the present invention is shown in Fig. 2. The strength of synapse coupling can be changed by this embodiment and therefore a neural network having learning function can be realized.

Fig. 2(a) is a schematic plan view and Fig. 2(b) is a cross-sectional view along X-X' line of Fig. 2(a). 201, 202 denote NMOS and PMOS transistor, respectively. 203 denotes a floating gate made of e.g. $N^+$-type polysilicon film and formed on the channel region of NMOS through a gate insulating film 204 of e.g. 200 Å thick. The floating gate 203 opposes to $N^+$ region 206 which acts as a charge injection electrode, holding $SiO_2$ film 205 of e.g. 50 - 70 Å thick between 207 is the gate electrode of PMOS transistor and capacitively coupled with the floating gate of NMOS transistor through e.g. a 200 Å thick $SiO_2$ film 208 and also act as a gate electrode of NMOS transistor 201. The electrode 207 is made of e.g. $N^+$-type polysilicon and connected to interconnect 210 made of e.g. Al through contact-hole 209. The Al interconnect is connected to the output of neuron circuit shown in e.g. Fig. 11 or 12.

211 is an electrode made of e.g. $WSi_2$ and capacitively coupled with floating gate 203 through $SiO_2$ film 212 of 200 Å thick. 213a, 214a are sources of NMOS and PMOS, respectively, and connected to one of the input terminals of the neuron at the next stage. 213b, 214b are the drains of NMOS and PMOS, respectively, and connected to a power supply line $V_{DD}$ and a ground line ($V_{SS}$), respectively.

In Fig. 2(a), $V_{DD}$, $V_{SS}$ and the interconnects to the neuron at the next stage are omitted to avoid undesirable complexity. In Fig. 2(b), 215, 216 denote a field oxide film and e.g. a P-type silicon substrate, respectively. Fig. 2(c) represents a semiconductor device having a synapse and a neuron by using symbol. In these figure, the same parts are indicated by the same numbers. 217 and 218a-218d denote a neuron circuit and its input terminals, corresponding to 101 and 102a-102d in Fig. 1, respectively.

As is clear from the comparison between Figs. 2(c) and 1(a), a synapse coupling is constructed by connecting NMOS and PMOS in series in this embodiment as well as the embodiment 1 except that NMOS has floating gate 203. During the regular operation where the potential of electrodes 211, 206 is set at 0 V NMOS transistor 201 operates in the same manner as described in the embodiment 1; that is, NMOS transistor acts as an enhancement type transistor which turns on when the voltage higher than $V_{TH}^n$ is applied to gate electrode 207. When the potential of signal line 210 becomes $V_{DD}$ and 0 V, $V_{DD}$-$V_{TH}^n$ and 0 V are inputted to 218a, respectively.

In order to explain in detail the performance of NMOS transistor having a floating gate, the corresponding part is taken and shown in Fig. 2(d) using symbol. The same numbers show the same parts in Figs. 2(a) - 2(d). 207, 211, 206, and 203 are a gate electrode (hereinafter abbreviated as G), a control gate to control the synapse strength (W), a charge injection electrode (C) and a floating gate (FG), respectively.

The potential Z of floating gate FG is given by

$$Z = (C_G V_G + C_W V_W + C_C V_C + Q_F)/(C_{OX} + C_C + C_W + C_G) \qquad (8)$$

Here, $Q_F$ is the amount of charges in the floating gate. $V_G$, $V_W$ and $V_C$ are the potential of electrodes G, W and C, respectively. $C_{OX}$, $C_C$, $C_W$ and $C_G$ are capacitive coupling coefficients between respective electrode and $F_G$ as defined in Fig. 2(d). The potential of the P-type silicon substrate is set to be 0 V.

As mentioned above, for $V_W = 0$ and $V_C = 0$, Eq. (8) is reduced to

$$Z = ( C_G V_G + Q_F )/C_{TOT}$$
$$C_{TOT} = C_{OX} + C_C + C_W + C_G \qquad (9)$$

The threshold voltage of NMOS transistor seen from FG, (i.e. the minimum value of FG potential which can cause NMOS to form channel) is defined as $V_{TH}^*$. Then NMOS turns on if

$$(C_G V_G + Q_F)/C_{TOT} > V_{TH}^*$$

or

$$V_G > (C_{TOT}/C_G)V_{TH}^* - Q_F/C_G.$$

In other words, the threshold voltage $V_{TH}^n$ seen from gate electrode 207 is given by:

$$V_{TH}^n = (C_{TOT}/C_G)V_{TH}^* - Q_F/C_G \qquad (10)$$

$C_{TOT}$, $C_G$, and $V_{TH}^*$ cannot be changed after the device is constructed because those values are determined by device structure and manufacturing process. However, $V_{TH}^n$ can be changed by modifying the value of $Q_F$ and therefor the weight of synapse coupling is changed according to Eq. 7.

Although both $V_W$ and $V_C$ has been assumed to be 0 V under regular operation, other choice of these values are also possible. In this case, Eq. 10 is revised as

$$V_{TH}^n = (C_{TOT}/C_G)V_{TH}^* - (Q_F/C_G) - (C_W/C_G)V_W - (C_C/C_G)V_C \qquad (11)$$

where only the terms proportional to $V_W$ and $W_G$ are added. Thus, $V_{TH}^n$ is determined by only $Q_F$ as far as $V_W$ and $V_C$ are kept constant.

The value of $Q_F$ can be changed in the following manner as an example. $V_{PP}$ is defined as a program voltage which is higher than $V_{DD}$. For example, $V_{DD}$ is set at 5 V, and $V_{PP}$, at 10 V. Here, $C_W = C_G = (C_{OX}/2) >> C_C$ is assumed for simplicity, which is easily achieved by the layout shown in Fig. 2(a). In the case of $V_C = 0$ and $V_W = V_G = V_{PP}$, $Z = (V_{PP}/2) = 5$ V is obtained from Eq. 8 under the assumption of $Q_F = 0$.

When the thickness of oxide film 205 is designated to be 50 Å, the electric field of 10 MV/cm is applied to the oxide film. Then Fowler-Nordheim tunneling current flows and electrons are injected into the FG from C, resulting in $Q_F < 0$.

$Z$ becomes smaller as $Q_F$ becomes negative as is apparent from Eq. 8, and therefore the tunneling current decreases and finally is cut off when a certain number of electrons are injected. In order to correctly control the charge injection, the value of $V_W$ and $V_G$ can be changed by using pulse. The absolute value of $Q_F$ is controlled by, for example, changing the number of pulses of constant width and height.

The electron injection is also made by changing the pulse of $V_C$. For example, after having set $V_W$, $V_G$ and $V_C$ at $V_{PP}$, only $V_C$ is decreased to 0 V by using pulses. The electron is injected and the amount of electron to be injected is controlled as well. The above-mentioned explanation refers to the case of $Q_F$ becoming negative where $V_{TH}^n$ becomes larger according to Eqs. 10 and 11, namely, corresponding to the operation to weaken the strength of synapse coupling.

Next, the operation to strengthen the synapse coupling is described. For this purpose, $V_W$ and $V_G$ are set at 0 and then $V_C$ is set to be $V_{PP}$. $Z$ becomes 0 V according to Eq. 8 and the election field of 10 MV/cm in the opposite direction this time is generated in the oxide film to make electrons emit from FG to C by Fowler-Nordheim tunneling injection. As a result, positive charges remain in FG and $Q_F$ becomes positive ($Q_F > 0$).

Eqs. 10 and 11 show that the value of $V_{TH}^n$ becomes larger and Eq. 7 shows that the value of W becomes larger. The condition corresponds to the operation to increase the synapse coupling strength. In order to increase the synapse coupling strength, it is also possible to increase only $V_C$ to $V_{PP}$ by using pulses, while $V_W = V_G = V_C = 0$ V holds. It is needless to say that the absolute value of $Q_F$ can be freely controlled by the pulse width, pulse height or pulse number.

Another essence of this method is to selectively change the strength of any synapse coupling. Four principal parts of synapses 212, 213, 214, 215, which are parts of NMOS having a floating gate, are arranged in matrix in Fig. 2(e). $G_1$ and $G_2$, corresponding to signal line 210, are installed in parallel with each other. $W_1$ and $W_2$, corresponding to a signal line 211, are also installed in parallel. When one synapse e.g. 212 is to be weakened, the potential of $V_{PP}$ is applied to $G_1$ and $W_1$, and 0 V to $G_2$ and $W_2$. Here, $V_C$ is set at 0 V. As explained in Fig. 2(d), electrons are injected into the floating gate at 212 and the coupling strength becomes small. At synapse 215, $V_W = V_G = 0$ and therefore $Z = 0$ V, which causes no electron tunneling, and no change in the value of W. At synapses 213, 214, $V_G = V_{PP}$, $V_W = 0$ or $V_G = 0$, $V_W = V_{PP}$. Then, $Z = (1/4) V_{PP} = 2.5$ V, which indicates that the electric field applied to oxide film 205 is 5 MV/cm, an half of that of synapse 212. Since the tunneling current changes exponentially with electric field strength, no tunneling current flows and therefore no change of $Q_F$ is observed at these synapses.

In other words, only the synapse located at the intersection of two lines, both of which are in high potential level $V_{PP}$, can have its coupling strength weakened. Thus, the coupling strength of the specific synapse can selectively be changed. In order to selectively increase the coupling strength, first $V_C = V_{PP}$ and then $G_1$, $G_2$, $W_1$ and $W_2$ are all set to be $V_{PP}$. The coupling strength of synapse 214 at the intersection is increased by reducing $G_2$ and $W_2$ to 0 V. Although the explanation has been done for the case of four synapses, it is apparent that the same selective change of coupling strength can be carried out for the case with more synapses in matrix arrangement.

In Fig. 2(e), only NMOS transistor are depicted for simple explanation. In practice, PMOS and relating interconnects shown in Figs. 2(a) - 2(c) are attached to each NMOS transistor.

The connection with neuron circuit 217 is explained in detail in the fourth embodiment.

In the neural network of this embodiment, single synapse coupling is constructed with one NMOS transistor and one PMOS transistor, and therefore the occupied area of synapse coupling is very small, which makes it possible to integrate synapse couplings in very high density. Furthermore, since the coupling strength can be determined by the charges stored in the floating gate, the coupling strength can be freely changed and also stored. That is, nearly the same function as biological synapse is realized with only two elements. In the case of a large number of synapse couplings arranged in matrix configuration, any synapse can be chosen and modified to have any value of strength. In addition, no direct current needs to flow to keep the output of synapse at constant value and therefore the power dissipation can be restricted to be very little, which is an ideal feature to construct ultra high integration neural network.

In the prior art synapse coupling configuration shown in Figs. 13 and 14, due to a large amount of power dissipation and the necessity of a large number of elements to memorize the value of coupling strength, it is almost impossible to have high integration density of synapse couplings, while the highly integrated neural network is for the first time realized by the present invention.

In the embodiment 2, $N^+$-type polysilicon is used as a material for electrodes 213, 217, $WSi_2$ for 211 and Al for 210. The other materials can also be used as far as they can attain the similar functions. The materials and thickness of insulating films 204, 205, 208, 212 are not restricted to those of this embodiment. Furthermore the charges injection electrode 206 which is installed independently in this embodiment can also be formed in th extended part of the source electrode 213a or drain electrode 213b. This configuration is preferable since the interconnect to apply the potential to electrode can be omitted. And polysilicon electrode can also be substituted for $N^+$ layer.

The selective modification of coupling strength is carried out by means of combination of voltages applied to two electrodes 211 (W), 207 (G) in the embodiment 2. 211(W) is the electrode for exclusive use, while 207 (G) acts also as the gate electrode of NMOS 203. Therefore, it is possible that another electrode exclusively used to modify the coupling strength is additionally formed in Fig. 2(d) and the amount of charge to be injected to FG is controlled by voltages applied to two electrodes.

As a method for injecting charge, avalanche injection or hot electron injection is also used instead of Fower-Nordheim tunneling injection.

Although a floating gate type MOS transistor is used to make the threshold of NMOS transistor variable in the embodiment 2, MNOS type device or non-volatile memory element with a ferroelectric film whose cross-sectional view is shown in Fig. 2(f) can be substituted. In Fig. 2(f), 216 denotes a P-type Si substrate, 217, an $SiO_2$ film of e.g. 50 Å thick, 218, a ferroelectric film such as 3000 Å thick PZT ( $Pb( Zr_xTi_{1-x})O_2$), 219, an electrode made of e.g. Ti, and 220a, 220b, $N^+$-type source and drain. Positive or negative pulse is applied to polarize the ferroelectric film and the threshold is controlled by the magnitude of polarization.

As mentioned above, any method is adopted to make the threshold of NMOS transistor variable. In the case of the configuration shown in Fig. 2, it has already been mentioned that the threshold of $V_{TH}^n$ can be controlled by the charge in the floating gate. It is apparent from Eq. 11 that the threshold can also be controlled by setting $V_W$ and $V_C$ at appropriate values; that is, the synapse coupling is modified by controlling the potential of $V_W$ and $V_C$.

In Fig. 1(a)( embodiment 1) and Figs. 2(a) and 2(c) (embodiment 2), PMOS transistor 107, 202 is inserted between NMOS 105, 201 and the ground ($V_{SS}$) line. The performance of PMOS transistor is explained below by referring to Fig. 1(b).

In the case of $V_{in} = V_{DD}$, $V_{out} = V_{DD} - V_{TH}^n$ and the charge of $C(V_{DD} - V_{TH}^n)$ is stored in the capacitor C. Then, if $V_{in}$ changes to 0 V, the PMOS transistor lets the charges in the capacitor C escape to the ground. Therefore, the PMOS transistor must be off when $V_{in} = V_{DD}$, and on when $V_{in} = 0V$.

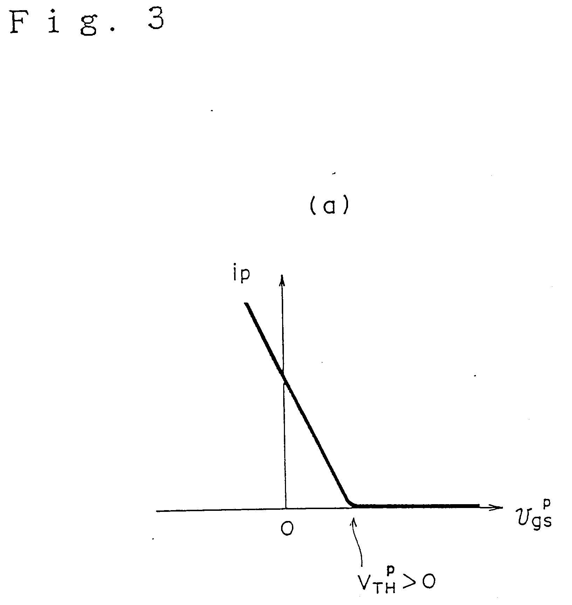

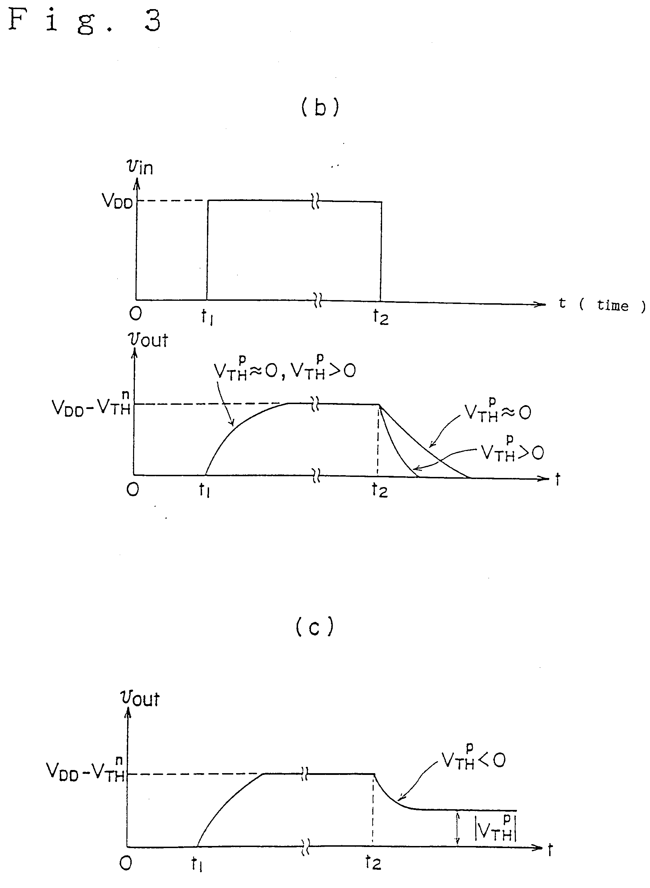

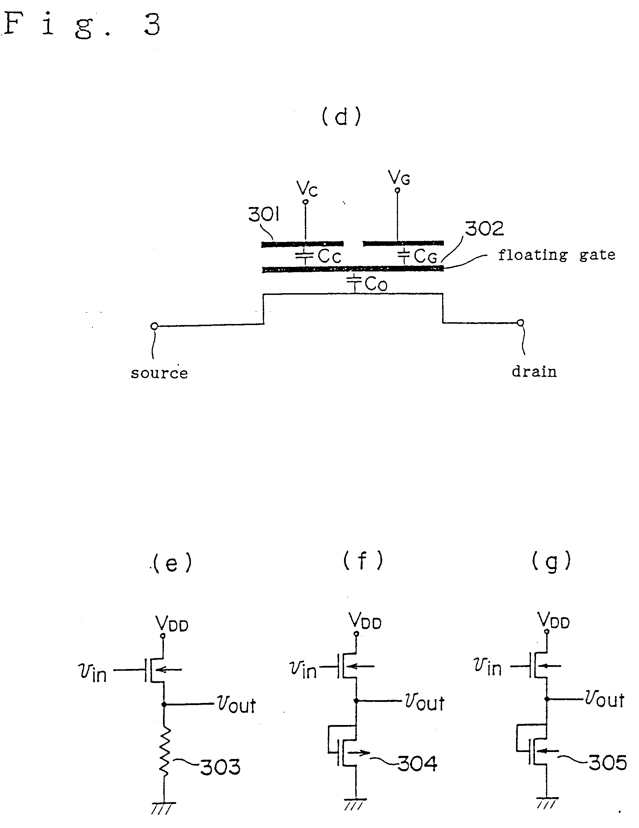

To shorten discharging time, the PMOS transistor should be designed so as to have a large current capacity. For this purpose, a depletion type PMOSFET shown in e.g. Fig. 3(a) is used. The voltage applied to the gate of PMOS at the moment when $V_{in}$ changes from $V_{DD}$ to 0 V is expressed by:

$$V_{gs}^p = - (V_{DD} - V_{TH}^n) < 0$$

Therefore, it is apparent from the comparison of Figs. 3(a) and 1(d) that more current flows in the transistor with $V_{TH}^p > 0$ than the transistor with $V_{TH}^p \fallingdotseq 0$.

Fig. 3(b) shows time response characteristics of the circuit shown in Fig. 1(b). The fall time is shortened by using a depletion type PMOS transistor although the rising characteristic is not improved because of being determined by the ON characteristic of NMOS transistor 105. The larger value of $V_{TH}^p$ makes the fall time shorter.

On the other hand, when $V_{in}$ changes from 0 to $V_{DD}$, NMOS transistors 105, 201 turn on under the condition of $V_{in} \geq V_{TH}^n$. Unless PMOS transistor is off, direct current flows from $V_{DD}$ to $V_{SS}$ ( ground ) and power dissipation becomes large. In order to prevent the direct current from flowing, the threshold of depletion type PMOS must be designated as:

$$0 < V_{TH}{}^p < V_{TH}{}^n \qquad (12)$$

To make discharging time of capacitor C as short as possible and achieve the high speed operation of the circuit, the following condition should hold besides $V_{TH}{}^p < V_{TH}{}^n$,

$$V_{TH}{}^p \fallingdotseq V_{TH}{}^n \qquad (13)$$

For PMOS transistors 107, 207, an enhancement type PMOSFET with $V_{TH}{}^p < 0$ can also be used. In this case, the time response characteristic of the circuit in Fig. 1(b) is shown in Fig. 3(c). The circuit has the same rising characteristic as that in Fig. 3(b), but there is quite a few differences in the falling characteristic. Namely, the output voltage stops changing at the point of $V_{out} = | V_{TH}{}^p|$ and maintained because the PMOS transistor turns off at the point. This voltage level actually decreases to 0V after a long time since the charges in the capacity C escape through the leakage of PN junction or the subthreshold current of P-channel MOS transistor.

Such synapse couplings can memorize the activated state for a while. Once the signal is inputted from a fired neuron (i.e. $V_{in} = V_{DD}$), the voltage of $V_{out}$, equal to $|V_{TH}{}^p|$, is held even after the output of the neuron falls in the low level. The holding time is controlled by e.g. connecting resistor R to PMOS transistor 107, 202 in parallel and the output voltage is gradually approaches to 0 V on the basis of time constant of RC. The level of output voltage is controlled by $V_{TH}{}^p$.

The synapse coupling having a variety of characteristics can be realized by changing $V_{TH}{}^p$ of PMOS transistor 107,202. The value of $V_{TH}{}^p$ can be set at an appropriate value by channel ion implantaion in manufacturing process. The threshold $V_{TH}{}^p$ can also be variable by adopting a floating gate type transistor structure and modifying charges in the floating gate, or by adopting the structure shown in Fig. 3(d) and modifying the value of $V_C$ or $C_C$. $V_{TH}{}^p$ is given by:

$$V_{TH}{}^p = (C_{TOT}/C_G)V_{TH}{}^* - (Q_F/C_G) - (C_C/C_G)V_C \qquad (14)$$

The value of $C_C$ can be changed with the overlapping area between electrode 301 and floating gate 302. If the overlapping area is appropriately designed at the stage of pattern layout, the manufacturing process becomes simple because ion implantation repeatedly carried out with various ion dose for each channel can be omitted. Furthermore, $V_{TH}{}^p$ can be changed by the value of $V_C$ and therefore only specific synapse can be maintained at activated state for a limited time.

So far the PMOS transistor which shares the common gate electrode with NMOS transistor has been used as an element to discharge the charges in capacitor C. But the feature of the present invention can be available when other types of load elements shown in Figs. 3(e), 3(f) and 3(g) are used. In these figure, only the part corresponding to Fig. 1(b) is shown. Namely, a resistor 303, a depletion type PMOS 304 with the gate connected to the source, or an enhancement type NMOS 305 with the gate connected to the drain are used in these figure in place of PMOS transistor. Furthermore, other load elements such as an enhancement type PMOS in which the gate is connected to the drain, a depletion type NMOS in which the gate is connected to source, or an MOS transistor in which a certain voltage is applied to the gate are used. Although the feature of low power dissipation is lost in these cases since direct current flows to hold the level of $V_{out}$, the power dissipation can be reduced by using a load with large effective resistance. These circuits are combined with e.g. variable threshold NMOS transistor 201 and used in the same manner as shown in the embodiment 2, which can provide a synapse with variable coupling strength and memory function. This feature can never be realized by the prior arts shown in Figs. 14(a) and 14(b).

(Embodiment 3)

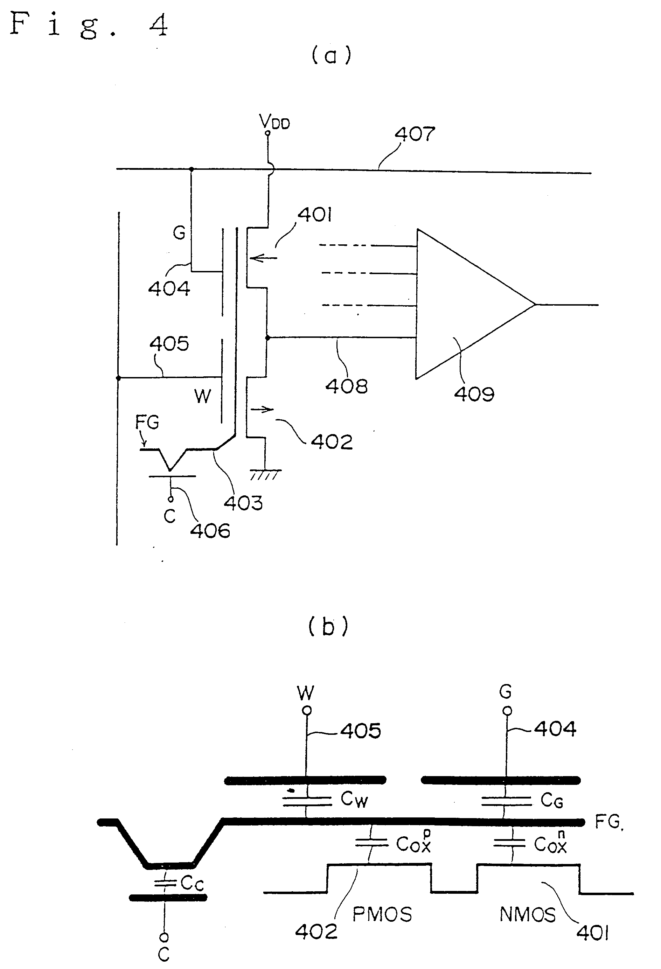

The third embodiment of this invention is described by referring to Fig. 4. The symbol of Fig. 4 has the same meanings as in Figs. 2(a) - 2(d).

401, 402 are respectively NMOS and PMOS transistors, and have common floating electrode (FG) 403, 404 is a gate electrode capacitively coupled with FG through an insulating film such as $SiO_2$ film, and acts as a common gate electrode (G) of NMOS 401 and PMOS 402. 405 and 406 are control gates (W) for adjusting synapse coupling and a charge injection electrode (C) similar to 211 and 206 in Fig. 2(c), respectively. The other structure is the same as that of the second embodiment; 407 denotes a signal line which transfers the output signal of a neuron at the previous stage and 408 denotes an interconnect to send the output of synapse to one of the input terminals of neuron 409 at the next stage.

In order to explain the operation of this embodiment, the part of synapse coupling is extracted from Fig. 4(a) and shown in Fig. 4(b). The voltage applied to electrodes G, W, and C are $V_G$, $V_W$ and $V_C$, respectively, and the potential of silicon substrate is 0 V, which yields the potential Z of FG as:

$$Z = (C_G V_G + C_W V_W + C_C V_C + Q_F)/C_{TOT}$$
$$C_{TOT} = C_{OX}^n + C_{OX}^p + C_G + C_W + C_C \qquad (15)$$

The threshold values at which inversion layer is formrd, as seen from NMOS and PMOS are denoted by $V_{TH}^{n*}$ and $V_{TH}^{p*}$, respectively. Then the threshold values $V_{TH}^n$, $V_{TH}^p$ seen from common gate electrode G of NMOS and PMOS are given by:

$$V_{TH}^n = (C_{TOT}/C_G)V_{TH}^{n*} - (Q_F/C_G) - (C_W/C_G)V_W - (C_C/C_G)V_C \qquad (16)$$

$$V_{TH}^p = (C_{TOT}/C_G)V_{TH}^{p*} - (Q_F/C_G) - (C_W/C_G)V_W - (C_C/C_G)V_C \qquad (17)$$

Certain constant potential is applied to $V_W$ and $V_C$ except while synapse coupling strength is being changed. For example, in the case of $V_W = V_C = 0$, Eqs. 16 and 17 are revised to Eqs. 16' and 17',

$$V_{TH}^n = (C_{TOT}/C_G)V_{TH}^{n*} - (Q_F/C_G) \qquad (16')$$

$$V_{TH}^p = (C_{TOT}/C_G)V_{TH}^{p*} - (Q_F/C_G) \qquad (17')$$

Both $V_{TH}^n$ and $V_{TH}^p$ can be changed by $Q_F$ and therefore the synapse coupling strength can be changed according to Eq. 7.

From Eqs. 16 and 17,

$$V_{TH}^n - V_{TH}^p = (C_{TOT}/C_G)(V_{TH}^{n*} - V_{TH}^{p*}) \qquad (18)$$

where $C_{TOT}$, $C_G$, $V_{TH}^{n*}$ and $V_{TH}^{p*}$ are determined by manufacturing process and therefore cannot be changed after the element is fabricated. In other words, $V_{TH}^n - V_{TH}^p$ is always constant and does not change even if the synapse coupling strength is changed.

This fact has a very important meaning as follows. It was described in the embodiment 2 using Fig. 3(a) and 3(b) that both using a depletion type PMOS transistor ( $V_{TH}^p > 0$ ) and increasing $V_{TH}^p$ as large as possible are effective in improving the falling characteristic of synapse.

In order to prevent large power dissipation due to the flow of direct current, the condition expressed by Eq. 12 is required.

$$V_{TH}^p < V_{TH}^n \qquad (12)$$

In the embodiment 2, only the threshold of NMOS transistor 201 is variable. Namely, $V_{TH}^n$ changes while $V_{TH}^p$ is kept constant. The condition of Eq.12 restricts the margin of $V_{TH}^p$. For example, when the value of $V_{TH}^n$ Is changed from 0 V to $V_{DD}$ (corresponds to the change of W from 1 to 0 ), $V_{TH}^p \fallingdotseq 0$ is inevitable to attain the condition of Eq. 12.

On the other hand, it is apparent from Eqs. 16 and 17 that $V_{TH}^n$ and $V_{TH}^p$ change together with each other and the difference is always kept constant, indicating that Eq. 12 always holds. Namely, by setting $V_{TH}^p$ and $V_{TH}^n$ as $V_{TH}^p \fallingdotseq V_{TH}^n$ and $V_{TH}^p < V_{TH}^n$ in the manufacturing process, it becomes possible to realize the optimum condition where lower power dissipation and shorter fall time can be achieved.

The third embodiment is similar to the embodiment 2 except that NMOS and PMOS share the floating gate in this embodiment. Therefore, the synapse coupling strength can be changed in the same manner.

(Embodiment 4)

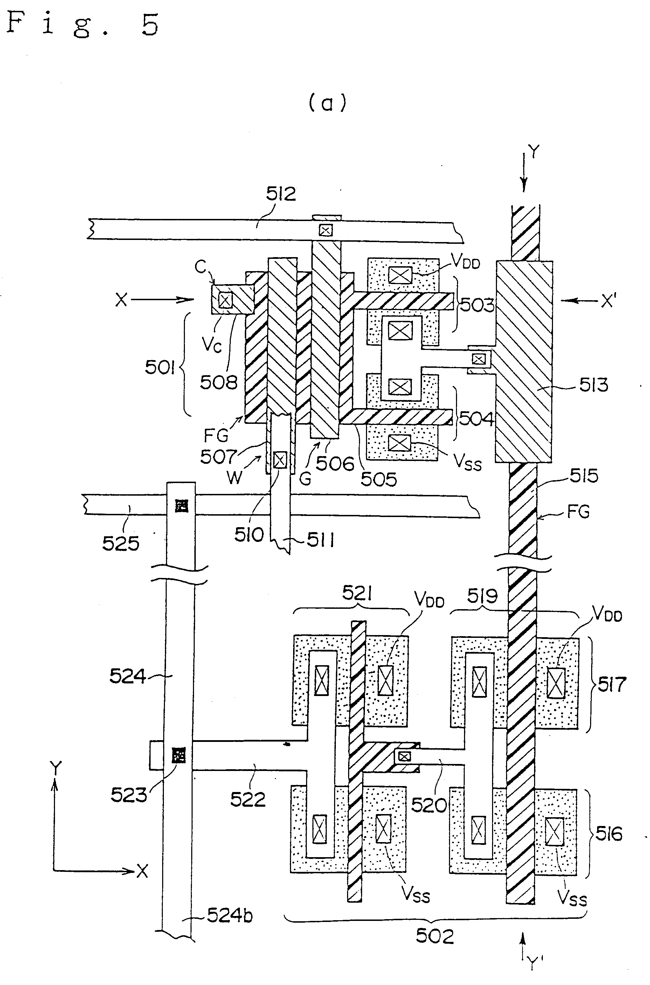

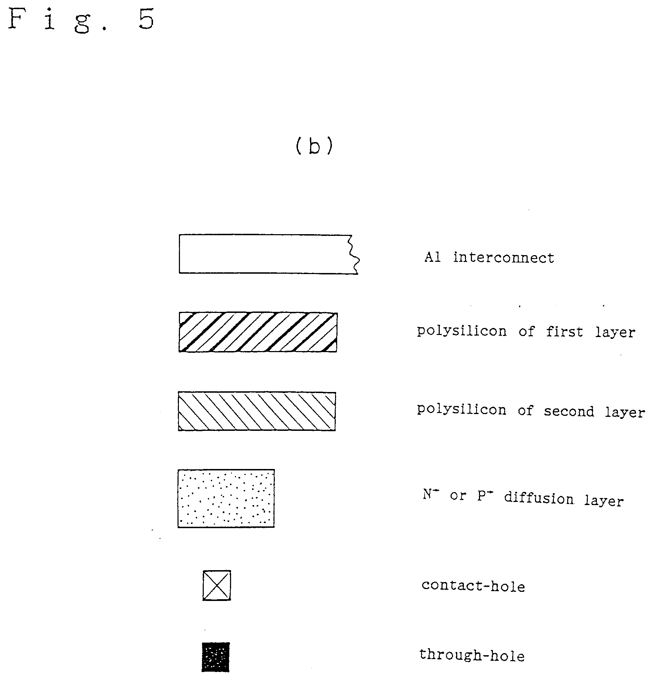

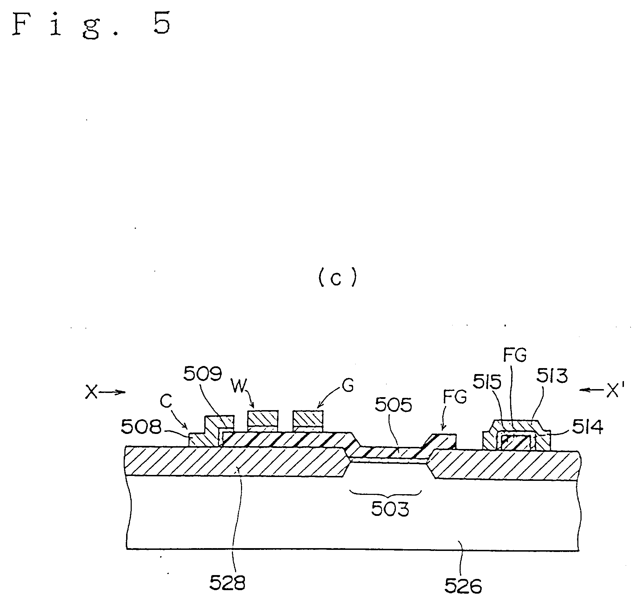

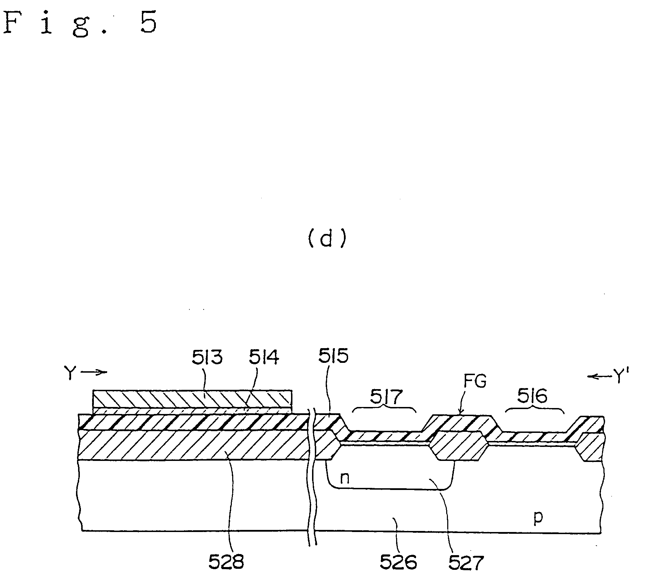

The fourth embodiment is explained using Fig. 5. Fig. 5(a) represents a layout of principal part of neural network which is composed of one synapse coupling and one neuron 502.

This circuit is constructed by CMOS process using bilayer polysilicon and bilayer Al interconnect technology. The materials used in Fig. 5(a) are shown in Fig. 5(b). Al interconnects running in the X direction are the interconnects of the first layer and those in the Y direction are the interconnects of the second layer. As for $V_{DD}$, $V_{SS}$ and $V_C$, Al interconnects are omitted in order to easily understand the layout.

The potential is applied through, for example, the Al interconnects of the first layer.

Figs. 5(c) and 5(d) are cross-sectional views along X-X' and Y-Y' lines of Fig. 5(a), respectively. 503, 504 are NMOS and PMOS transistors, respectively, and 505 is a common floating gate (FG) to both transistors. 506, 507 and 508 are a gate electrode (G) common for both NMOS and PMOS, a control gate for changing synapse coupling (W) and a charge injection electrode (C),respectively. Here, concrete pattern of the circuit which has the same function as that shown in Fig. 4(a) is expressed

In this embodiment, charge injection electrode 508 is formed with polysilicon of the second layer over polysilicon electrode 505 through e.g. about 70 Å thick thermal oxidation film 509 (see Fig. 5(c)). It is also possible to use $N^+$ diffusion layer as shown in the embodiment 2.

W 507 is connected to Al interconnect 511 of the second layer through contact-hole 510. G 506 is connected to signal line 512 which is connected to the output terminal of neuron in the same manner as 103 in Fig. 1(a) and 210 in Fig. 2(a).

513 is capacitively coupled with floating gate (FG) 515 through insulating film 514, and 515 is the floating gate of both NMOS 516 and PMOS 517 transistors, constructing CMOS neuron gate 519, which corresponds to Fig. 12(a) and 1210 in Fig. 12(b). The output is inputted through Al interconnect 520 to CMOS inverter 521, the output of which appears in Al interconnect 522 of the first layer. Here, the output is connected to the Al interconnect 524 of the second layer through through-hole 523, and connected to Al interconnect 525 which is parallel with 512. The interconnect 524 expands downwards as shown by 524b which acts as an output line to the neuron in the next layer. The detail is explained in the embodiment 5.

A signal line 525 forms a signal line to feed back the output of neuron 502 to the input terminal of the same neuron and therefore is connected to e.g. the neuron 502 through a synapse circuit such as 501. In the figure, 526, 527 and 528 denote P-type Si substrate, N-well and field oxide film, respectively. As mentioned above, the most important function of neural network including feed-back function can be constructed on a very small chip area by this embodiment. This embodiment is easily applied to a neural network composed of a large number of neurons.

(Embodiment 5)

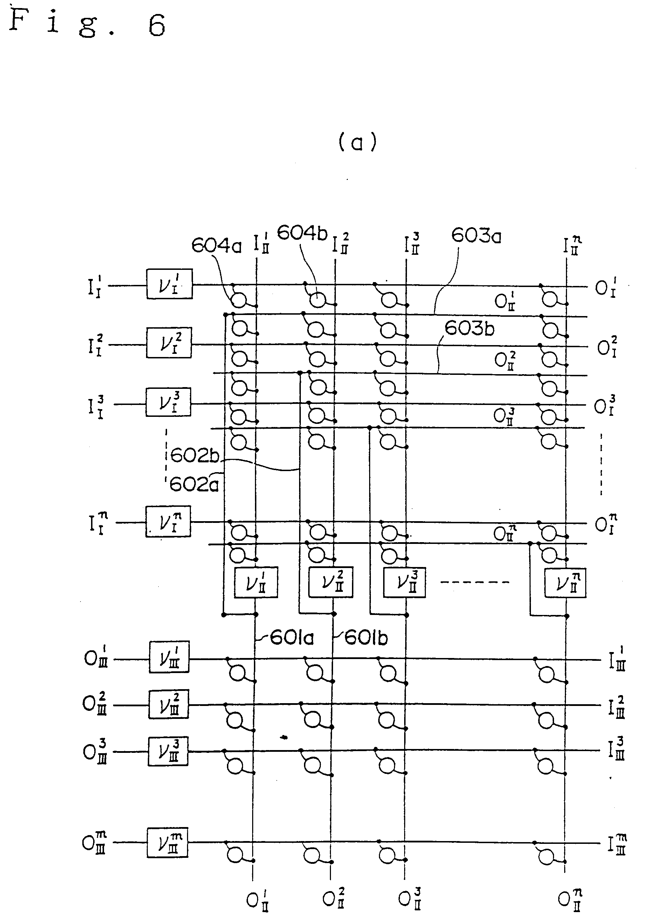

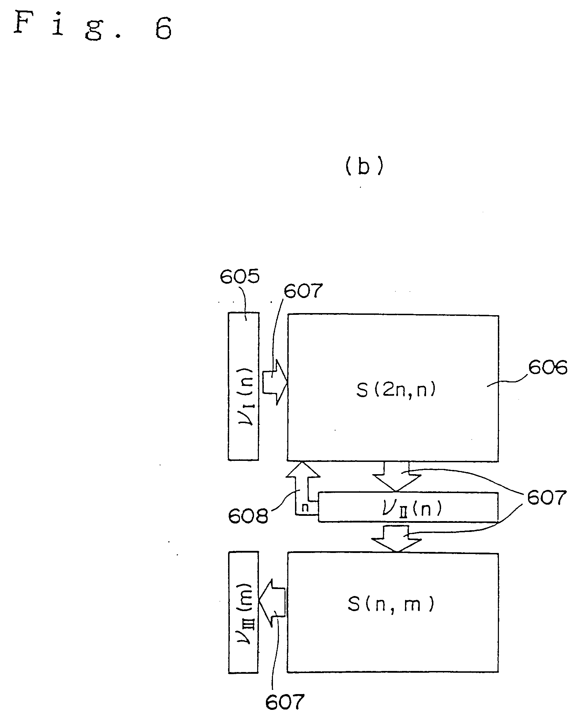

Fig. 6(a) is a diagram to explain the fifth embodiment of the invention. $\nu_I^1$, $\nu_I^2$, $\cdots,\nu_I^n$ denote a group of n neurons in the first layer, each of which has a circuit similar to 502 in Fig. 5(a). $\nu_{II}^1$, $\nu_{II}^2$, $\cdots$, $\nu_{II}^n$ and $\nu_{III}^1$, $\nu_{III}^2$, $\cdots$, $V_{III}^n$ are groups of n neurons in the second and third layers, respectively. Each neuron has structure similar to 502. $O_I^1$, $O_I^2$, $\cdots$, $O_I^n$ are output lines from neurons in the first layer and corresponds to signal line 512 in Fig. 5(a).

$I_{II}^1$, $I_{II}^2$, $\cdots,I_{II}^n$ are input lines of neuron group in the second layer, and correspond to floating gate 515 in Fig. 5(a). $O_{II}^1$, $O_{II}^2$, $\cdots$, $O_{II}^n$ are output lines of neuron group in the second layer, and some of them are connected to input lines of neuron group in the third layer through interconnects such as 601a, 601b, or connected through interconnects 602a, 602b to interconnects such as 603a, 603b which are parallel with the output lines of the first layer neuron group to form feed-back loop.

601a, 602a and 603a corresponds to interconnects 524b, 524 and 525. The synapse coupling circuits such as 604a, 604b correspond to e.g. 501 in Fig. 5(a).

This embodiment shows a layout of neural network consisting of neuron groups of three layers. It is apparent that the present invention makes possible to construct neural network by regularly arranging the circuit in two dimension, which is very suitable for LSI.

Fig. 6(a) is simplified and then shown in Fig. 6(b). $\nu_I(n)$ in 605 denotes a group of neurons in the first layer where n means that the neuron group is composed of n neurons. S(2n,n) in 606 is called synapse matrix and denotes a group of synapse arranged in matrix which combines 2n outputs ( the sum of n outputs of the first layer and n outputs feed backed from the second layer) and n inputs to the second layer. The arrow 607 means the flow of signals and the arrow 608 means that n outputs are feed-backed. By using such notation, more complicated neural network can be expressed simply.

(Embodiment 6)

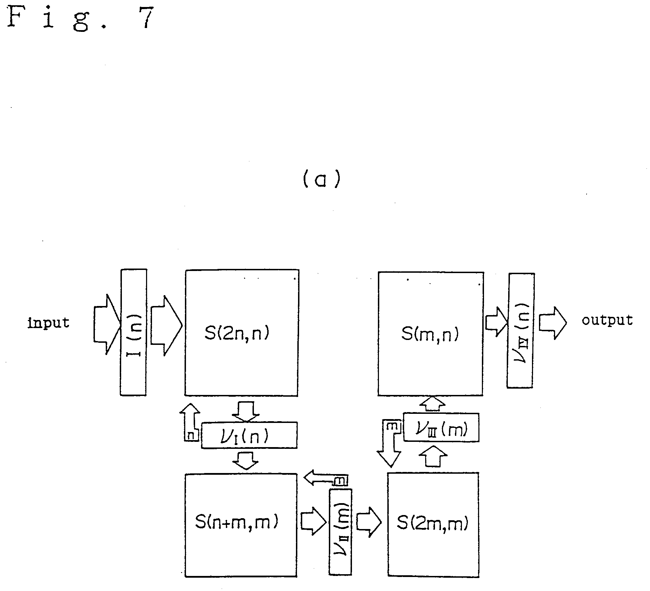

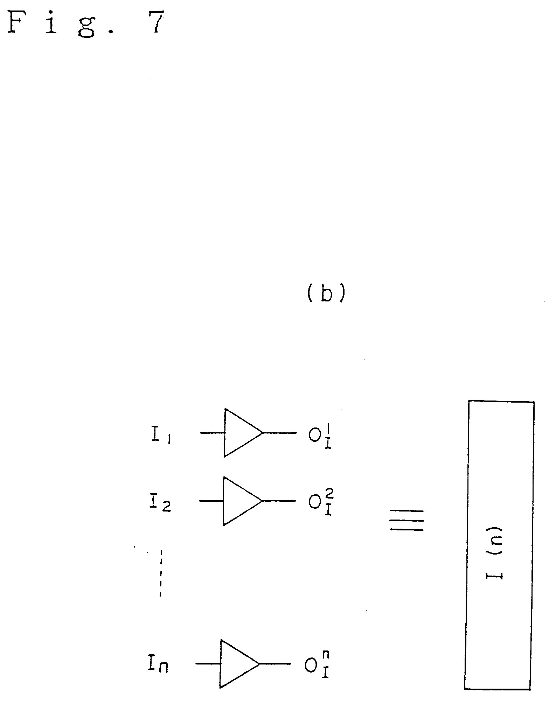

Fig. 7 shows the sixth embodiment of the invention where a four-layer neural network is expressed by using the notation of Fig. 6(b). Here, I(n) denotes a input buffer layer composed of n amplifiers as shown in Fig. 7(b) which output the potential level of 0 V or $V_{DD}$ for each of binary input signals $I_1$, $I_2$, $\cdots$, $I_n$ of 0 or 1.

As is apparent from Fig. 7(a), four layer neural network having feed-back function is realized by two-dimensional, regular arrangement.

The human brain is said to be composed of six layers of neuron groups. The neural network with more layers can easily be constructed by the repetitions of the same plane arrangement. That is, the semiconductor device of the present invention have very advantageous feature for realizing a neuron computer.

(Embodiment 7)

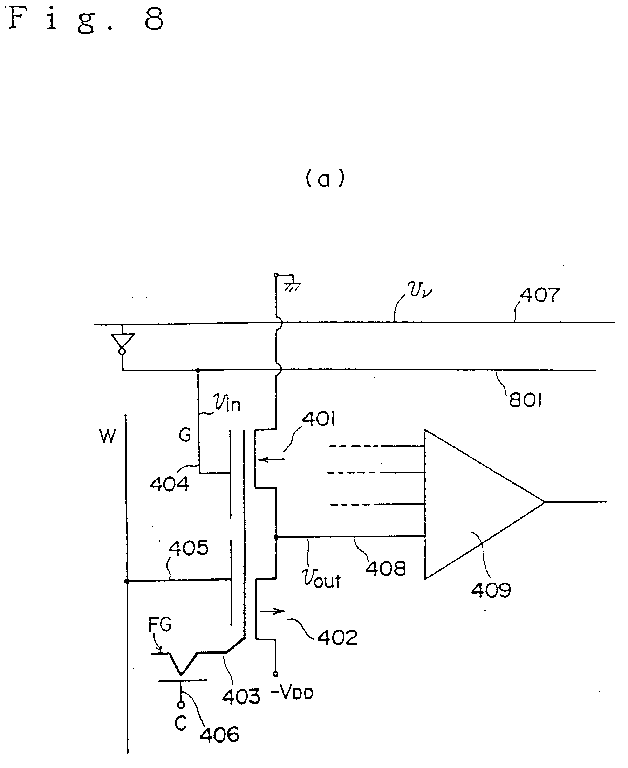

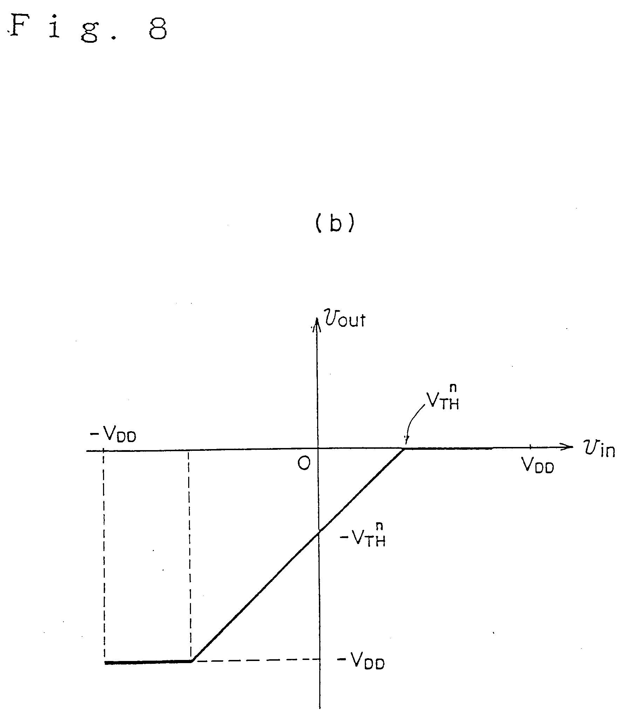

Fig. 8 is a diagram showing the seventh embodiment which is similar to Fig. 4(a) except that the drain of NMOS 401 is connected to 0V, the drain of PMOS 402 to $-V_{DD}$ and G to signal line 801.

Fig. 8(b) shows the relationship between $V_{in}$ ( potential of 404) and $V_{out}$ ( potential of 408), where $V_{TH}^n$ is a threshold seen from the gate electrode 404 of NMOS transistor 401. Therefore, $V_{out} = 0$ when $V_{in} = V_{DD}$, and $V_{out} = V_{TH}^n$ when $V_{in} = 0$. From the figure, $V_{in}$ is equal to the potential of signal line 801, which is equal to the inverted potential of that of signal line 407. Therefore, $V_{in} = 0$ when the neuron in the previous stage is fired, and $V_{in} = V_{DD}$ when the neuron is not fired, indicating that the synapse transmits negative output of $-V_{TH}^n$ to the neuron at the next stage when the neuron at the previous stage gets fired. That is, the synapse, an inhibitory synapse, performs so as to restrain the neuron at the next stage from firing.

As mentioned above, an inhibitory of organism can easily constructed according to the present invention. Being expressed by $-V_{TH}^n$, An inhibitor level is controlled by changing the amount of charge in the floating gate.

In all embodiment of this invention, the explanation has been made for the case where interconnects such as 103, 210, 407 etc are connected to the output of neuron; however, this invention are not restricted to such cases. For example, this invention is also available for the case of the interconnects being connected to the output of input buffer. It is also possible that output data of neuron are supplied to these interconnects through a pass transistor after being latched in e.g. flip-flop or supplied through an appropriate amplifier.

**Industrial applicability**

As mentioned above, the semiconductor device of the present invention realizes a neural network having nearly the same function as human brain and low power dissipation characteristic by a small number of elements. The semiconductor device can be regarded as the most appropriate device to realize a neuron computer since complicated neural network is constructed by regularly arranging elements in matrix.

**Claims**

1. A semiconductor device comprising a first semiconductor region on a substrate, first source and first drain regions of opposite conductivity type to that of said first semiconductor region formed in the said first semiconductor region, a first gate electrode floating in potential formed over the region separating said first source and first drain regions through a first insulating film, a plurality of second gate electrodes capacitively coupled with said first electrode through a second insulating film, and a first MOS type transistor,
   wherein the source electrode of said first MOS type transistor is connected to one of said second gate electrodes and at least the gate or the drain electrode of said first MOS type transistor is connected to a first interconnect which transfers two-level voltage signal of high or low level.

2. The semiconductor device according to claim 1, wherein said first MOS type transistor has a gate structure to change its threshold to a prescribed value.

3. The semiconductor device according to claim 2, wherein said first MOS type transistor has a floating gate.

4. The semiconductor device according to claim 2, wherein said first MOS type transistor is an MNOS ( Metal - Nitride - Oxide - Semiconductor) type transistor.

5. The semiconductor device according to one of claims 1 to 4, wherein said first MOS type transistor is N-channel type, the source electrode of which is connected to A low level power supply line through a second MOS type transistor of P-channel type and the gate electrodes of said first and second MOS type transistors are connected to said first interconnect.

13

6. The semiconductor device according to claim 5, wherein said second MOS type transistor is an enhancement type.

7. The semiconductor device according to claim 5, wherein the threshold of said second MOS type transistor is nearly 0 V.

8. The semiconductor device according to claims 5, wherein said second MOS type transistor is a depletion type.

9. The semiconductor device according to one of claims 3, 5, 6, 7, and 8, comprising at least one third gate electrode capacitively coupled with said floating gate of said first MOS transistor through a third insulating film, and a charge injection electrode opposing to said floating gate through a fourth insulating film,
wherein charge transfer occurs through said fourth insulating film between said floating gate and said charge injection electrode by applying prescribed potential to said third gate electrode and said charge injection electrode.

10. The semiconductor device according to claim 3 or 5, comprising said second MOS type transistor having a floating gate electrically connected to the floating gate of said first MOS type transistor, at least one third gate electrode capacitively coupled with said floating gate through a third insulating film, and a charge injection electrode opposing to said floating gate through a fourth insulating film,
wherein charge transfer occurs through said fourth insulating film between said floating gate and said charge injection electrode by applying prescribed potential to said third gate electrode and said charge injection electrode.

11. The semiconductor device according to one of claims 1 to 10, wherein a plurality of said first interconnects are arranged in parallel with each other, and a plurality of said first gate electrodes are arranged in parallel with each other and perpendicular to said first interconnects.

12. The semiconductor device according to claims 1, comprising first, second, and third power supply lines for supplying high level, medium level and low level voltages, respectively, and said first MOS type transistor being N-channel type,
wherein said first interconnect transfers first signal with two potential levels of high and low levels which correspond to the potential of said first and second power supply lines, respectively, the drain of said first MOS type transistor is connected to said second power supply line, and the inversion of said first signal is inputted to the gate electrode of said first MOS type transistor.

13. The semiconductor device according to claim 12, wherein said first MOS transistor has a floating gate.

14. The semiconductor device according to claim 12 or 13, wherein the source of said first MOS type transistor is connected to said third power supply line through a P-channel MOS type transistor.

Fig. 1

(a)

(b)

# F i g .  1

(c)

$V_{TH}^{n} > O$

(d)

$V_{TH}^{p} \fallingdotseq O$

(e)

# Fig. 2

(a)

to the input of neuron

(b)

# Fig. 2

(c)

(d)

channel region

# Fig. 2

(e)

(f)

Fig. 3

(a)

ip

$V_{TH}^{p} > 0$

$\mathcal{U}_{gs}^{p}$

O

# Fig. 3

(b)

(c)

# Ｆｉｇ．３

(d)

$V_C$    $V_G$

301    302    floating gate

$\doteq C_C$    $\doteq C_G$

$\doteq C_O$

source    drain

(e)    (f)    (g)

$V_{DD}$    $V_{DD}$    $V_{DD}$

$v_{in}$ ─    $v_{in}$ ─    $v_{in}$ ─

$v_{out}$    $v_{out}$    $v_{out}$

303    304    305

# Fig. 4

## (a)

## (b)

23

# Fig. 5

## (a)

# Fig. 5

## (b)

| | |
|---|---|
| ☐ | Al interconnect |
| ▨ | polysilicon of first layer |
| ▨ | polysilicon of second layer |
| ▦ | $N^-$ or $P^+$ diffusion layer |
| ⊠ | contact-hole |
| ■ | through-hole |

# F i g . 5

(c)

# Fig. 5

(d)

F i g. 6

(a)

# F i g . 6

(b)

# Fig. 7

(a)

input → I(n) → S(2n,n) → $\nu_\mathrm{I}(n)$ → S(n+m,m) → $\nu_\mathrm{II}(m)$ → S(2m,m) → $\nu_\mathrm{III}(m)$ → S(m,n) → $\nu_\mathrm{IV}(n)$ → output

# Fig. 7

$(b)$

$$I_1 \longrightarrow\!\!\!\!\triangleright\!\!- O_I^1$$

$$I_2 \longrightarrow\!\!\!\!\triangleright\!\!- O_I^2$$

$$\vdots$$

$$I_n \longrightarrow\!\!\!\!\triangleright\!\!- O_I^n \qquad \equiv \qquad I(n)$$

# Fig. 8

## (a)

# Fig. 8

(b)

# Fig. 9

# Fig. 10

(a)

$V_1 \rightarrow W_1 \rightarrow$

$V_2 \rightarrow W_2 \rightarrow$

$V_3 \rightarrow W_3 \rightarrow$

$V_n \rightarrow W_n \rightarrow$

$V_{out}$

Fig. 10

(b)

$$Z = \sum_{i=1}^{n} w_i V_i$$

Fig. 11

(a)

F i g. 1 1

(b)

# Fig. 11

## (c)

# Fig. 11

(d)

Fig. 12

(a)

# Fig. 12

(b)

# F i g .  1 3

Fig. 14

(a)

# Fig. 14

(b)

4-bit counter

1402

| A₃ |
| A₂ |
| A₁ |
| A₀ |

$A_3$ $A_2$ $A_1$ $A_0$ → D/Λ converter → $V_{GG}$

1403

control signal

# INTERNATIONAL SEARCH REPORT

International Application No PCT/JP92/00014

**I. CLASSIFICATION OF SUBJECT MATTER** (if several classification symbols apply, indicate all) [6]

According to International Patent Classification (IPC) or to both National Classification and IPC

Int. Cl$^5$ G06G7/60

**II. FIELDS SEARCHED**

Minimum Documentation Searched [7]

| Classification System | Classification Symbols |
|---|---|
| IPC | G06G7/60 |

Documentation Searched other than Minimum Documentation
to the Extent that such Documents are Included in the Fields Searched [8]

Kokai Jitsuyo Shinan Koho        1972 - 1992

**III. DOCUMENTS CONSIDERED TO BE RELEVANT** [9]

| Category [*] | Citation of Document, [11] with indication, where appropriate, of the relevant passages [12] | Relevant to Claim No. [13] |
|---|---|---|
| A | JP; A, 2-74053 (Intel Corp.), March 14, 1990 (14. 03. 90), Line 5, lower left column, page 269 to line 18, upper left column, page 271 (Family: none) | 1-14 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| April 7, 1992 (07. 04. 92) | May 12, 1992 (12. 05. 92) |

| International Searching Authority | Signature of Authorized Officer |
|---|---|
| Japanese Patent Office | |

Form PCT/ISA/210 (second sheet) (January 1985)